(19) **Europäisches Patentamt European Patent Office Office européen des brevets**

(11) **EP 4 716 290 A1**

(12) **EUROPEAN PATENT APPLICATION**
published in accordance with Art. 153(4) EPC

(43) Date of publication:
**25.03.2026 Bulletin 2026/13**

(51) International Patent Classification (IPC):
*H04W 28/06* (2009.01)

(21) Application number: **23941013.7**

(52) Cooperative Patent Classification (CPC):
**H04W 28/06**

(22) Date of filing: **14.06.2023**

(86) International application number:
**PCT/CN2023/100144**

(87) International publication number:
**WO 2024/254776 (19.12.2024 Gazette 2024/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Huawei Technologies Co., Ltd.**
**Shenzhen, Guangdong 518129 (CN)**

(72) Inventors:
• **MA, Mengyao**
**Shenzhen, Guangdong 518129 (CN)**

• **MA, Jianglei**
**Shenzhen, Guangdong 518129 (CN)**
• **LI, Jiahui**
**Shenzhen, Guangdong 518129 (CN)**
• **DU, Yuqing**
**Shenzhen, Guangdong 518129 (CN)**
• **XIE, Junwen**
**Shenzhen, Guangdong 518129 (CN)**

(74) Representative: **Goddar, Heinz J.**
**Boehmert & Boehmert**
**Anwaltspartnerschaft mbB**
**Pettenkoferstrasse 22**
**80336 München (DE)**

(54) **COMMUNICATION METHOD AND APPARATUS**

(57) A communication method and apparatus are provided. The method includes: obtaining to-be-compressed data, where the to-be-compressed data includes first data; determining at least one first transform base based on a first data type of the first data; determining second data based on the at least one first transform base and the first data; and sending the second data to a first device. According to the method provided in this application, a unified compression framework based on a transform base is proposed for the to-be-compressed data. At least one first transform base can be flexibly determined based on a data type of the first data, so that the first data is compressed based on the at least one first transform base. This ensures compression performance, enhances compression efficiency, and reduces data transmission overheads.

FIG. 3

**Description**

<u>TECHNICAL FIELD</u>

This application relates to the field of wireless communication technologies, and in particular, to a communication method and apparatus.

<u>BACKGROUND</u>

As wireless communication application scenarios become increasingly diversified, a large amount of data oriented to new scenarios is generated in a next-generation wireless communication process. The data brings new requirements on transmission. For example, in a future 6th generation (6th generation, 6G) system, there may be data such as imaging data, distributed artificial intelligence (artificial intelligence, AI) data, and channel state information (channel state information, CSI) data. The data usually features a large data amount, high redundancy, time/frequency/-space correlation, and the like. For example, the imaging data has high sparsity, and positioning/tracking data, environment imaging/reconstruction data, AI training data, or the like obtained in continuous time has high time correlation.

In a mobile communication system, if the data oriented to new scenarios is directly processed such as encoded and modulated, and then sent, a large quantity of channel resources are occupied. Therefore, how to reduce transmission overheads of the data is a problem that needs to be resolved.

<u>SUMMARY</u>

An objective of implementations of this application is to provide a communication method and apparatus, to reduce data transmission overheads.

According to a first aspect, this application provides a communication method. The method may be applied to a second device, a processor in the second device, a chip or a chip system in the second device, a functional module, or the like. The method may include: obtaining to-be-compressed data, where the to-be-compressed data includes first data; determining at least one first transform base based on a first data type of the first data; determining second data based on the at least one first transform base and the first data; and sending the second data to a first device.

According to the method provided in this application, a unified compression framework based on a transform base is proposed for the to-be-compressed data. At least one first transform base can be flexibly determined based on a data type of the first data, so that the first data is compressed based on the at least one first transform base. This ensures compression performance, enhances compression efficiency, and reduces data transmission overheads.

In a possible design, determining the at least one first transform base based on the first data type of the first data includes: determining, from at least one piece of transform base indication information, first transform base indication information corresponding to the first data type, and using a transform base indicated by the first transform base indication information as the at least one first transform base.

According to the method, a transform base corresponding to the first data is determined from the at least one piece of transform base indication information, so that the transform base can be flexibly configured, and compression performance can be ensured.

In a possible design, the method further includes: receiving the at least one piece of transform base indication information.

In a possible design, the at least one piece of transform base indication information is preconfigured; or the at least one piece of transform base indication information is generated in real time.

If the transform base indication information is preconfigured, efficiency of obtaining the transform base can be enhanced. If the transform base indication information is generated in real time, configuration overheads of the transform base indication information can be reduced, and a transform base that better matches data can be generated based on an actual application scenario.

In a possible design, the transform base indication information includes at least one of the following: first information, indicating a data type; second information, indicating one or more transform bases; third information, indicating a constraint relationship between data and the one or more transform bases indicated by the second information; and fourth information, indicating valid time of the one or more transform bases indicated by the second information.

In a possible design, the method further includes: receiving configuration information, where the configuration information indicates a transform base set, the transform base set includes Q transform bases, and Q is an integer greater than 0.

In a possible design, the configuration information further indicates a correspondence between a data type and a transform base set.

According to the method, transform base sets corresponding to different data types are indicated/configured in advance, so that an index of a desired transform base in a transform base set may be directly indicated in a process of using the transform base. This is applicable to different compression requirement scenarios and reduces transform base indication overheads.

In a possible design, that the second information indicates the transform bases includes: The second information includes one or more transform bases in the Q transform bases, or the second information includes indexes of the one or more transform bases in the Q transform bases.

According to the method, when the second information includes the indexes in the Q transform bases, a configuration of a transform base can be flexibly changed, and transform base indication overheads can be reduced.

In a possible design, the at least one first transform base and the first data satisfy any one of the following constraint relationships: $X=BT$; $X \approx BT$; $T=BX$; $T=XB$; $X=B_1 TB_2$; $X \approx B_1 TB_2$; and $T=B(X)$.

X indicates the first data, T is used to determine the second data, and the at least one first transform base includes a transform base B or B(), or the at least one first transform base includes a transform base $B_1$ and a transform base $B_2$.

In a possible design, the method further includes: sending first indication information to the first device, where the first indication information indicates the at least one first transform base.

According to the method, the at least one first transform base is indicated to the first device, so that the first device can more accurately restore the first data from the second data based on the at least one first transform base.

In a possible design, the at least one first transform base includes a second transform base and a third transform base, and determining the second data based on the at least one first transform base and the first data includes: determining third data based on the second transform base and the first data; and determining the second data based on the third transform base and the third data.

According to the method, the first data may be compressed for a plurality of times through cascading use of a plurality of transform bases, to enhance compression efficiency and reduce data transmission overheads.

In a possible design, the to-be-compressed data further includes fourth data, and the method further includes: determining at least one fourth transform base based on a second data type of the fourth data, where the second data type is different from the first data type; and determining the second data based on the at least one first transform base and the first data includes: determining fifth data based on the at least one first transform base and the first data, and determining sixth data based on the at least one fourth transform base and the fourth data; and determining the second data based on the fifth data and the sixth data.

According to the method, jointly compressing a plurality of pieces of data can reduce compression time and enhance data compression efficiency.

In a possible design, the determining the second data based on the at least one first transform base and the first data includes: determining eighth data based on the at least one first transform base and the first data, where the eighth data includes at least two elements; selecting at least one element from the at least two elements in the eighth data; and determining the second data based on the at least one element.

In a possible design, the method further includes: sending second indication information to the first device, where the second indication information indicates location information of each of the at least one element in the at least two elements.

According to a second aspect, this application provides a communication method. The method may be applied to a first device, a processor in the first device, a chip or a chip system in the first device, a functional module in the first device, or the like. The method may include: receiving second data from a second device; determining at least one first transform base based on a first data type of the second data; and restoring seventh data from the second data based on the at least one first transform base.

In a possible design, determining the at least one first transform base based on the first data type of the second data includes: determining, from at least one piece of transform base indication information, first transform base indication information corresponding to the first data type, and using a transform base indicated by the first transform base indication information as the at least one first transform base.

In a possible design, the method further includes: sending the at least one piece of transform base indication information.

In a possible design, the at least one piece of transform base indication information is preconfigured.

In a possible design, the transform base indication information includes at least one of the following: first information, indicating a data type; second information, indicating one or more transform bases; third information, indicating a constraint relationship between data and the one or more transform bases indicated by the second information; and fourth information, indicating valid time of the one or more transform bases indicated by the second information.

In a possible design, the method further includes: sending configuration information, where the configuration information indicates a transform base set, the transform base set includes Q transform bases, and Q is an integer greater than 0.

In a possible design, the configuration information further indicates a correspondence between a data type and a transform base set.

In a possible design, that the second information indicates the transform bases includes: The second information includes one or more transform bases in the Q transform bases, or the second information includes indexes of the one or more transform bases in the Q transform bases.

In a possible design, the method further includes: receiving first indication information, where the first indication information indicates the at least one first transform base.

In a possible design, the at least one first transform base includes a second transform base and a third transform base; and restoring the seventh data from the second data based on the at least one first transform base includes: determining ninth data based on the third transform base and the second data; and determining the seventh data based on the second transform base and the ninth data.

In a possible design, the second data is determined based on fifth data and sixth data, the fifth data is determined based on the at least one first transform base and the first data, the sixth data is determined based on at least one fourth transform base and fourth data, and a second data type of the fourth data is different from the first data type; and restoring the seventh data from the second data based on the at least one first transform base includes: restoring tenth data from the fifth data based on the at least one first transform base, restoring eleventh data from the sixth data based on the at least one fourth transform base, and determining the seventh data based on the tenth data and the eleventh data.

According to a third aspect, this application further provides a communication apparatus. The communication apparatus may be a second device. The communication apparatus has functions of implementing the first aspect or the possible design examples of the first aspect. The functions may be implemented by hardware, or may be implemented by hardware executing corresponding software. The hardware or the software includes one or more modules corresponding to the foregoing functions.

In a possible design, a structure of the communication apparatus includes a communication unit and a processing unit. These units may perform corresponding functions in the first aspect or the possible design examples of the first aspect. For details, refer to detailed descriptions in the method examples. Details are not described herein.

In a possible design, a structure of the communication apparatus includes a transceiver and a processor, and optionally, further includes a memory. The transceiver is configured to: receive and send signals, and is configured to communicate and interact with another device in a system. The processor is configured to support the communication apparatus to perform corresponding functions in the first aspect or the possible design examples of the first aspect. The memory is coupled to the processor, and stores program instructions and data necessary for the communication apparatus.

According to a fourth aspect, this application further provides a communication apparatus. The communication apparatus may be a first device. The communication apparatus has functions of implementing the second aspect or the possible design examples of the second aspect. The functions may be implemented by hardware, or may be implemented by hardware executing corresponding software. The hardware or the software includes one or more modules corresponding to the foregoing functions.

In a possible design, a structure of the communication apparatus includes a communication unit and a processing unit. These units may perform corresponding functions in the second aspect or the possible design examples of the second aspect. For details, refer to detailed descriptions in the method examples. Details are not described herein.

In a possible design, a structure of the communication apparatus includes a transceiver and a processor, and optionally, further includes a memory. The transceiver is configured to: receive and send messages, and is configured to communicate and interact with another device in a system. The processor is configured to support the communication apparatus to perform corresponding functions in the second aspect or the possible design examples of the second aspect. The memory is coupled to the processor, and stores program instructions and data necessary for the communication apparatus.

According to a fifth aspect, this application provides a communication system. The communication system may include a second device, a first device, and the like. The second device has functions of implementing the first aspect or the possible design examples of the first aspect. The first device has functions of implementing the second aspect or the possible design examples of the second aspect.

According to a sixth aspect, an embodiment of this application provides a computer-readable storage medium. The computer-readable storage medium stores program instructions; and when the program instructions are run on a computer, the computer is caused to perform the method according to any one of the first aspect and the possible designs of the first aspect in embodiments of this application, or the method according to any one of the second aspect and the possible designs of the second aspect in embodiments of this application. For example, the computer-readable storage medium may be any usable medium that can be accessed by the computer. As an example rather than a limitation, the computer-readable medium may include a non-transitory computer-readable medium, a random access memory (random access memory, RAM), a read-only memory (read-only memory, ROM), an electrically erasable programmable read-only memory (electrically EPROM, EEPROM), a CD-ROM or another optical disk storage, a magnetic disk storage medium or another magnetic storage device, or any other medium that can carry or store desired program code in a form of an instruction or a data structure and that can be accessed by the computer.

According to a seventh aspect, an embodiment of this application provides a computer program product, including computer program code or instructions. When the computer program code or the instructions are run on a computer, the method according to any one of the first aspect or the possible designs of the first aspect, or the method according to any one of the second aspect or the possible designs of the second aspect is performed.

According to an eighth aspect, this application further provides a chip, including a processor. The processor is coupled to a memory, and is configured to read and execute program instructions stored in the memory, so that the chip implements the method according to any one of the first aspect or the possible designs of the first aspect or according to any one of the second aspect or the possible designs of the second aspect.

For each of the third aspect to the eighth aspect and technical effect that can be achieved by each aspect, refer to the foregoing descriptions of the technical effect that can be achieved by the first aspect, the possible solutions in the first aspect, the second aspect, or the possible solutions in the second aspect. Details are not described herein again.

BRIEF DESCRIPTION OF DRAWINGS

FIG. 1 is a diagram of an architecture of a communication system applicable to an embodiment of this application;

FIG. 2 is a schematic flowchart of data processing according to an embodiment of this application;

FIG. 3 is a schematic flowchart of a communication method according to an embodiment of this application;

FIG. 4 is a diagram of data compression according to an embodiment of this application;

FIG. 5 is a diagram of data compression according to an embodiment of this application;

FIG. 6 is a diagram of data compression according to an embodiment of this application;

FIG. 7 is a diagram of data compression according to an embodiment of this application;

FIG. 8 is a diagram of data compression according to an embodiment of this application;

FIG. 9 is a diagram of data compression according to an embodiment of this application;

FIG. 10 is a diagram of data compression according to an embodiment of this application;

FIG. 11 is a diagram of a structure of a communication apparatus according to an embodiment of this application; and

FIG. 12 is a diagram of a structure of a communication apparatus according to an embodiment of this application.

DESCRIPTION OF EMBODIMENTS

The following further describes in detail embodiments of this application with reference to the accompanying drawings.

A communication method provided in embodiments of this application may be applied to a 4th generation (4th generation, 4G) communication system, for example, a long term evolution (long term evolution, LTE) system, or may be applied to a 5th generation (5th generation, 5G) communication system, for example, a 5G new radio (new radio, NR) system, or may be applied to various future communication systems, for example, a 6th generation (6th generation, 6G) communication system. The communication method provided in embodiments of this application may be further applied to other fields, including but not limited to vehicle to everything (vehicle to everything, V2X) communication, device to device (device to device, D2D) communication, an internet of vehicles, autonomous driving, assisted driving, wireless fidelity (wireless fidelity, Wi-Fi), and the like.

A method and an apparatus provided in embodiments of this application are based on a same or similar technical concept. Because problem resolving principles of the method and the apparatus are similar, mutual reference may be made to implementations of the apparatus and the method. Repeated descriptions are not described.

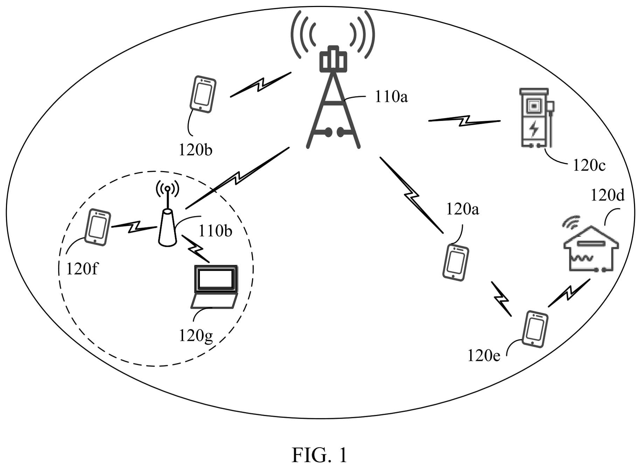

FIG. 1 is a diagram of an architecture of a communication system applicable to an embodiment of this application.

As shown in FIG. 1, the communication system may include at least one radio access network device (for example, 110a and 110b in FIG. 1), and may further include at least one terminal device (for example, 120a to 120g in FIG. 1). The terminal device is connected to the radio access network device in a wireless manner, and the radio access network device is connected to a core network in a wireless or wired manner. The terminal devices may be further connected to each other in a wired or wireless manner. For example, the terminal device 120a and the terminal device 120e in the figure are connected to each other in a wireless manner. FIG. 1 is merely a diagram. The communication system may further include other network devices, for example, may further include a wireless relay device and a wireless backhaul device, which are not shown in FIG. 1.

The terminal device in embodiments of this application may also be referred to as user equipment (user equipment, UE), a mobile station (mobile station, MS), a mobile terminal (mobile terminal, MT), or the like, and is a device that provides voice and/or data connectivity for a user. For example, the terminal device may be a hand-held device, a vehicle-mounted device, or the like that has a wireless connection function. Currently, some examples of the terminal device may be as follows: a mobile phone (mobile phone), a tablet computer, a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self driving (self driving), a wireless terminal in a remote medical surgery (remote medical surgery), a wireless terminal in a smart grid (smart grid), a wireless terminal in transportation safety (transportation safety), a wireless terminal in a smart city (smart city), a wireless terminal in a smart home (smart home), and the like.

In embodiments of this application, a network device may also be referred to as an access network device. The access network device may be a radio access network (radio access network, RAN) node (or device) like a base station that connects the terminal device to a wireless network. Some examples of the RAN node may be as follows: a next-generation NodeB (next-generation NodeB, gNB), a transmission reception point (transmission reception point, TRP), an evolved NodeB (evolved NodeB, eNB), a radio network controller (radio network controller, RNC), a NodeB (NodeB, NB), a base station controller (base station controller, BSC), a base transceiver station (base transceiver station, BTS), a home base station (for example, a home evolved NodeB, or home NodeB, HNB), a base band unit (base band unit, BBU), a wireless fidelity (wireless fidelity, Wi-Fi) access point (access point, AP), or the like.

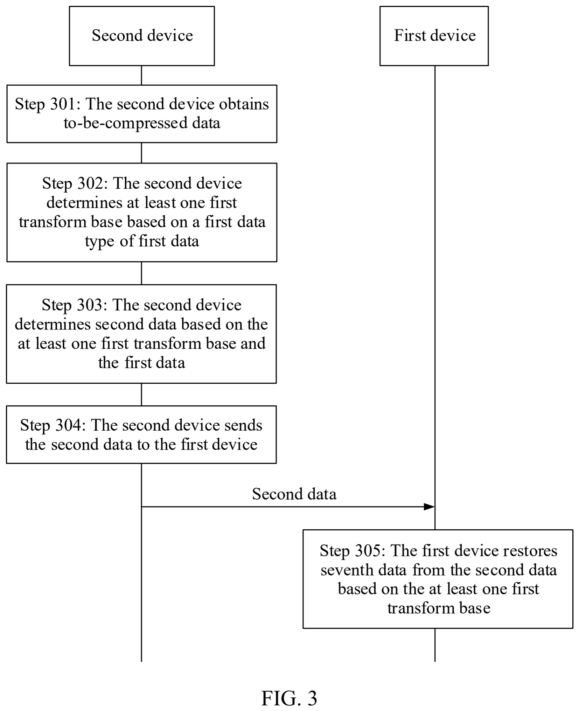

In a possible network structure, the access network device may include a central unit (central unit, CU) node or a distributed unit (distributed unit, DU) node, or include the CU node and the DU node. An RAN device that includes the CU node and the DU node splits protocol layers of a gNB in an NR system. Functions of a part of the protocol layers are centrally controlled by a CU, functions of a part or all of remaining protocol layers are distributed in a DU, and the CU centrally controls the DU, as shown in FIG. 3. Further, the CU may be further divided into a control plane (CU-CP) and a user plane (CU-UP). The CU-CP is responsible for a control plane function, mainly including radio resource control (radio resource control, RRC) and a packet data convergence protocol (packet data convergence protocol, PDCP) corresponding to the control plane (namely, PDCP-C). The PDCP-C is mainly responsible for data encryption and decryption, integrity protection, data transmission, and the like on the control plane. The CU-UP is responsible for a user plane function, mainly including a service data adaptation protocol (service data adaptation protocol, SDAP) and a PDCP corresponding to the user plane (namely, PDCP-U). The SDAP is mainly responsible for processing data of the core network and mapping a flow (flow) to a bearer. The PDCP-U is mainly responsible for encryption and decryption, integrity protection, header compression, serial number maintenance, data transmission, and the like on a data plane. The CU-CP and the CU-UP are connected through an El interface. The CU-CP, on behalf of the gNB, is connected to the core network through an NG interface and connected to the DU through an F1 interface-control plane (namely, F1-C). The CU-UP is connected to the DU through an F1 interface-user plane (namely, F1-U). Certainly, in another possible implementation, the PDCP-C is alternatively in the CU-UP.

In embodiments of this application, the function of the network device may alternatively be performed by a module (for example, a chip) in the network device, or may be performed by a control subsystem including the function of the network device. The control subsystem including the function of the network device may be a control center in the foregoing application scenarios such as smart grid, industrial control, intelligent transportation, and smart city. The function of the terminal device may alternatively be performed by a module (for example, a chip or a modem) in the terminal device, or may be performed by an apparatus including the function of the terminal device.

A large amount of data is exchanged between the terminal device and the network device, or between the terminal devices. As wireless communication application scenarios become increasingly diversified, the data usually features a large data amount, high redundancy, and the like. However, if obtained data is directly processed such as encoded and modulated, and then sent, a large quantity of channel resources are occupied. In addition, in many scenarios, a receive end does not need to obtain original data, and may receive data obtained after lossy compression is performed on the original data. In other words, the receive end does not need to restore the original data completely.

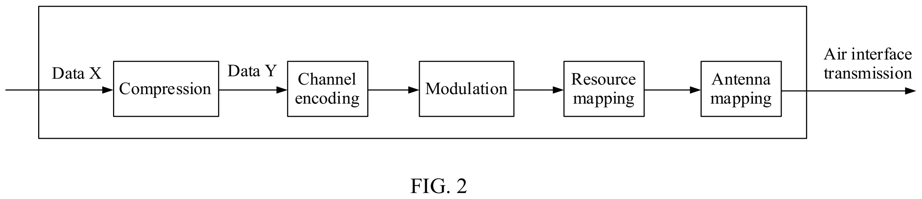

For example, as shown in FIG. 2, it is assumed that to-be-sent data is X, and the data X may be physical layer (physical layer) data, RAN native data, or the like. If the data X is directly transmitted, a large quantity of time-frequency resources are required. Therefore, the data X may be compressed to obtain data Y, and the data Y is sent to the receive end (for example, a base station). A data type of the data X is not limited. For example, the data X may be sensing/imaging data, CSI data, AI data, or the like. The data X may alternatively be data obtained after preprocessing. Before being sent, the data Y may further undergo other processing, for example, channel coding (channel coding), modulation (modulation), resource mapping (resource mapping), and antenna mapping (antenna mapping), and be finally transmitted through an air interface.

Therefore, in this application, a compression based on transform base (compression based on transform base, CTB) framework is used, so that data may be compressed based on a data type of the data, to reduce data transmission overheads.

A network architecture and a service scenario described in embodiments of this application are intended to describe the technical solutions in embodiments of this application more clearly, and do not constitute a limitation on the technical solutions provided in embodiments of this application. A person of ordinary skill in the art may know that: With the evolution of the network architecture and the emergence of new service scenarios, the technical solutions provided in embodiments of this application are also applicable to similar technical problems.

In this application, names of messages and information in the following procedures are merely used as examples. With the evolution of communication technologies, names of messages and information in the following procedures may change. However, regardless of how the names change, provided that meaning of the messages is the same as a function or meaning of messages in this application, the messages fall within the protection scope of this application. A sequence of steps in the following procedures is merely an example. In actual application, the sequence of steps in each procedure may be adjusted.

It may be understood that a specific structure of an execution entity of the method provided in embodiments of this application is not particularly limited in this application, provided that a program that records code of the method provided in embodiments of this application can be run to perform communication according to the method provided in embodiments of this application. The following uses interaction between the first device and the second device as an example for description.

With reference to the foregoing descriptions, FIG. 3 is a schematic flowchart of a communication method according to an embodiment of this application. The method includes the following steps.

Step 301: A second device obtains to-be-compressed data.

The second device may be a terminal device, or may be a network device. This is not limited in this application.

Details about how the second device obtains the to-be-compressed data are not limited in this application. For example, the second device may perform channel measurement to obtain CSI data, and the CSI data may be used as the to-be-compressed data. For example, the second device may perform sensing measurement to obtain sensing data, and the sensing data may be used as the to-be-compressed data.

The to-be-compressed data includes one or more types of data, for example, includes first data and fourth data. A data type of the first data is a first data type, a data type of the fourth data is a second data type, and the second data type is different from the first data type. The to-be-compressed data may be physical layer data, or may be RAN native data, or the like. This is not limited in this application.

Step 302: The second device determines at least one first transform base based on the first data type of the first data.

The first data type of the first data is not limited in this application. For example, the first data may be data of any one of the following data types: sensing data (or preprocessed sensing data), imaging data (or preprocessed imaging data), CSI data (or preprocessed CSI data), AI model data (or preprocessed AI model data), positioning data (or preprocessed positioning data), point cloud data (or preprocessed point cloud data), and ray tracing (ray tracing) data (or preprocessed ray tracing data).

The foregoing descriptions are merely examples. The first data may alternatively be data of another type. This is not limited in this application.

In this application, a transform base and data may satisfy a constraint relationship. The constraint relationship may be preset, or may be configured on a network side. In an implementation of the solution of this application, the at least one first transform base and the first data satisfy any one of the following constraint relationships:

$$X=BT; \quad X\approx BT; \quad T=BX; \quad T=XB; \quad X=B_1TB_2; \quad X\approx B_1TB_2; \quad T=B_1XB_2; \text{ and } T=B(X)$$

X indicates the first data, and X may be a vector or a matrix. T indicates compressed data or transformed data, T is used to determine second data, and T may be a vector or a matrix. The at least one first transform base includes a transform base B, or the at least one first transform base includes a transform base $B_1$ and a transform base $B_2$, or the at least one first transform base includes a transform base B().

The transform base may be a vector, a matrix, or a function. Specifically, when the transform base is a vector or a matrix, the transform base may be one vector or matrix, for example, B, or a group of vectors or matrices, for example, $B_1$ and $B_2$. When the transform base is a function B(), a function relationship between the transform base and the first data may be specifically BX or $B_1XB_2$. The function relationship between the transform base and the first data may alternatively be a function of a higher power that is of the first data, or may be transformation of a coordinate system. For example, the function relationship is specifically spherical coordinate projection performed on point cloud data in the following example.

For example, when a constraint relationship between X and B is X≈BT or X=BT, X is a vector including M elements, and B is a matrix including M×N elements. X≈BT is used as an example. In this case, X≈BT may be represented as follows:

$$\begin{bmatrix} x_0 \\ ... \\ x_{(M-1)} \end{bmatrix} \approx \begin{bmatrix} b_{00} & ... & b_{0(N-1)} \\ & ... & \\ b_{(M-1)0} & ... & b_{(M-1)(N-1)} \end{bmatrix} \times \begin{bmatrix} t_0 \\ ... \\ t_{(N-1)} \end{bmatrix}$$

T is a vector including N elements.

For example, when a constraint relationship between X and B is X≈BT or X=BT, X is a matrix including M×K elements, and B is an M×N matrix. X≈BT is used as an example. In this case, X≈BT may be represented as follows:

$$\begin{bmatrix} x_{00} & ... & x_{0(K-1)} \\ & ... & \\ x_{(M-1)0} & ... & x_{(M-1)(K-1)} \end{bmatrix} \approx \begin{bmatrix} b_{00} & ... & b_{0(N-1)} \\ & ... & \\ b_{(M-1)0} & ... & b_{(M-1)(N-1)} \end{bmatrix} \times \begin{bmatrix} t_{00} & ... & t_{0(K-1)} \\ & ... & \\ t_{(N-1)0} & ... & t_{(N-1)(K-1)} \end{bmatrix}$$

T is a matrix including N×K elements.

For example, when a constraint relationship between X and B is T=BX, X is a vector including M elements, and B is an M×N matrix. In this case, T=BX may be represented as follows:

$$\begin{bmatrix} t_0 \\ ... \\ t_{(N-1)} \end{bmatrix} = \begin{bmatrix} b_{00} & ... & b_{0(N-1)} \\ & ... & \\ b_{(M-1)0} & ... & b_{(M-1)(N-1)} \end{bmatrix} \times \begin{bmatrix} x_0 \\ ... \\ x_{(M-1)} \end{bmatrix}$$

T is a vector including N elements.

For example, when a constraint relationship between X and B is T=BX, X is a matrix including M×K elements, and B is a matrix including N×M elements. In this case, T=BX may be represented as follows:

$$\begin{bmatrix} t_{00} & ... & t_{0(K-1)} \\ & ... & \\ t_{(N-1)0} & ... & t_{(N-1)(K-1)} \end{bmatrix} = \begin{bmatrix} b_{00} & ... & b_{0(M-1)} \\ & ... & \\ b_{(N-1)0} & ... & b_{(N-1)(M-1)} \end{bmatrix} \times \begin{bmatrix} x_{00} & ... & x_{0(K-1)} \\ & ... & \\ x_{(M-1)0} & ... & x_{(M-1)(K-1)} \end{bmatrix}$$

T is a matrix including N×K elements.

For example, B is a function, and a constraint relationship between X and B is T = B(X). The constraint relationship may be represented as follows: (θ, φ, r) = B(x, y, z), where T = (θ, φ, r), X = (x, y, z).

$$\theta = \arcsin(z/\sqrt{x^2 + y^2 + z^2}), \varphi = arccos\ (x/\sqrt{x^2 + y^2}), \text{and}\ r = \sqrt{x^2 + y^2 + z^2}$$

For example, B is a function, and a constraint relationship between X and B is T = B(X). The constraint relationship may be represented as follows: (Ø, R, z) = B(x, y, z), where T = (Ø,R,z),X = (x, y, z). Ø=arccos(x/ $\sqrt{x^2 + y^2}$ ), and

$$R = \sqrt{x^2 + y^2}\ .$$

For example, a constraint relationship between X and B is X=$B_1TB_2$ or X≈$B_1TB_2$. It is assumed that X is an M×K matrix, and singular value decomposition (singular value decomposition, SVD) may be performed on X. In this case, $X = U\Sigma V^T = B_1TB_2$, where $B_1$=U, indicates a left singular matrix of X, and is an M×N matrix; $B_2$=V, indicates a right singular matrix of X, and is an L×K matrix; and T=Σ, indicates a singular value matrix of X, and is an N×L matrix.

The foregoing descriptions are merely examples. The at least one first transform base and the first data may alternatively satisfy another constraint relationship. This is not limited in this application.

In this application, there are a plurality of implementations for specifically determining a transform base based on a data type.

In an implementation, the second device may generate the at least one first transform base that satisfies the constraint relationship with the first data type of the first data. The constraint relationship is preset or configured by a network.

The second device may flexibly determine, based on the data type, the at least one first transform base, namely, an expression form of a first transform base, a parameter in the first transform base, and the like. For example, the first data is point cloud data or AI model data, and the first data is represented in a matrix form. If projection transformation needs to be performed on the first data to obtain a sparser matrix, the constraint relationship may be preset as T=BX or T=XB. X is the first data, and B is the first transform base. For example, if the preset constraint relationship is T=BX, and the first data X is an N×L matrix, the first transform base B generated by the second device is an M×N matrix.

For example, the first data is CSI data, and if spatial domain and frequency domain transformation needs to be performed on the first data, the constraint relationship may be $T=B_1XB_2$. X is the first data, $B_1$ and $B_2$ are the first transform bases, and $B_1$ and $B_2$ are discrete Fourier transform (discrete Fourier transform, DFT) matrices. For example, if the first data X is an N×L matrix, the first transform base $B_1$ generated by the second device is an M×N matrix, and $B_2$ is an L×K matrix.

For example, the first data is CSI data, and the first data is represented in a matrix form. If matrix decomposition needs to be performed on the first data to obtain a sparser matrix, the constraint relationship may be $X=B_1TB_2$. X is the first data, and $B_1$ and $B_2$ are the first transform bases. For example, if the first data X is an M×K matrix, the first transform base $B_1$ generated by the second device is an M×N matrix, and $B_2$ is an L×K matrix. $B_1$ may be a left singular matrix of X, $B_2$ may be a right singular matrix of X, and T may be a singular value matrix of X.

For example, if the first data is point cloud data, and spherical coordinate projection needs to be performed on the first data, the constraint relationship may be T=B(X), where T=(θ, φ, r), and X=(x, y, z).

$$\theta = \arcsin(z/\sqrt{x^2+y^2+z^2}),\ \varphi = arccos(x/\sqrt{x^2+y^2}),\ \text{and } r = \sqrt{x^2+y^2+z^2}.$$

For example, if the first data is point cloud data, and cylindrical coordinate projection needs to be performed on the first data, the constraint relationship may be T=B(X), where T=(Ø, R, z), and X=(x, y, z). $\emptyset = arccos(x/\sqrt{x^2+y^2})$, and $R = \sqrt{x^2+y^2}$.

In an implementation, the second device may determine, from at least one piece of transform base indication information, first transform base indication information corresponding to the first data type, and use a transform base indicated by the first transform base indication information as the at least one first transform base.

The at least one piece of transform base indication information is configured by a first device, or the at least one piece of transform base indication information is configured by a neighboring device of the second device, or the at least one piece of transform base indication information is preconfigured.

For example, it is assumed that the first device is a network device, the network device may send a configuration message, and the configuration message may include the at least one piece of transform base indication information. The configuration message may be signaling such as terminal device-specific configuration signaling, broadcast signaling, or common configuration signaling.

In this application, each piece of transform base indication information in the at least one piece of transform base indication information may indicate information such as one or more transform bases and data types corresponding to the one or more transform bases. In an implementation, the transform base indication information includes at least one of the following:

first information, indicating the data types corresponding to the one or more transform bases;
second information, indicating the one or more transform bases;
third information, indicating a constraint relationship between data and the one or more transform bases indicated by the second information; and
fourth information, indicating valid time of the one or more transform bases indicated by the second information.

For example, the at least one piece of transform base indication information obtained by the second device may be shown in Table 1.

Table 1

| Data type (first information) | Transform base (second information) | Constraint relationship (third information) | Valid time (fourth information) |
|---|---|---|---|
| Sensing data | Bs | X=BsT | 100 ms (ms) |
| CSI data | $B_1$ and $B_2$ | $X=B_1TB_2$ | 200 ms |

(continued)

| Data type (first information) | Transform base (second information) | Constraint relationship (third information) | Valid time (fourth information) |
|---|---|---|---|
| Point cloud data | B() | T=B(X), where | 200 ms |
| | | $(\theta, \varphi, r)$=B(x, y, z), T=$(\theta, \varphi, r)$, and X=(x, y, z) | |

In Table 1, the second device obtains three pieces of transform indication information. For example, the first data is sensing data. The second device may determine, according to Table 1, that a transform base corresponding to the first data is Bs, and determine that a constraint relationship is X=BsT. In this way, the second device may determine second data T based on the first data and the transform base Bs.

In this application, content indicated by the information may be preset. For example, if the transform base indication information does not include the first information, the data type may be a preset data type, for example, the preset data type is point cloud data. For another example, if the transform base indication information does not include the second information, the transform base may be a preset transform base.

In this application, the second information may directly indicate the one or more transform bases. For example, the second information includes the one or more transform bases. The second information may alternatively indirectly indicate the one or more transform bases. For example, the second information includes indexes of the one or more transform bases.

In an implementation, the second information includes a value of each element in the transform base. For example, the transform base is a matrix B, where $B \in \mathbb{R}^{M \times N}$. Specifically, the matrix B may be represented as follows:

$$B = \begin{bmatrix} b_{00} & \cdots & b_{0(N-1)} \\ \cdots & \cdots & \cdots \\ b_{(M-1)0} & \cdots & b_{(M-1)(N-1)} \end{bmatrix}$$

In this implementation, the second information may include a specific value of each element $b_{mn}$ in the matrix B, where 0≤m<M, and 0≤n<N.

In an implementation, the second information includes a calculation formula of each element in the transform base.

For example, the transform base is a matrix B, where $B \in \mathbb{R}^{M \times N}$. Specifically, the matrix B may include M×N elements. It is assumed that the matrix B is a discrete Fourier transform (discrete Fourier transform, DFT) matrix. In this case, an element that is in an mth row and an nth column in the matrix B and that is included in the second information is $b_{mn}$ = $e^{-2\pi mn/N}$, where 0≤m<M, and 0≤n<N.

For another example, the transform base is a function B. It is assumed that the function B is a projection function, and data X=(x, y, z). In this case, the function B included in the second information satisfies: $(\theta, \varphi, r)$=B(x, y, z). $\theta = \arcsin(z/\sqrt{x^2 + y^2 + z^2})$, $\varphi = arccos(x/\sqrt{x^2 + y^2})$, and $r = \sqrt{x^2 + y^2 + z^2}$.

In an implementation, the second device may obtain configuration information. The configuration information indicates at least one transform base set, one transform base set includes Q transform bases, and Q is an integer greater than 0. Quantities of transform bases included in different transform base sets may be the same or different. The configuration information may further indicate a correspondence between a data type and a transform base set. When a transform base set corresponding to a data type includes a plurality of transform bases, granularities/precisions of different transform bases in the plurality of transform bases are different, to adapt to different compression ratio requirement scenarios. For example, in a transform base set in Table 2 below, a dimension of a transform base whose index corresponding to CSI data is 010 is a 64×1024 matrix, and a dimension of a transform base whose index corresponding to CSI data is 011 is a 64×512 matrix. The dimension of the former transform base is greater than the dimension of the latter transform base. A compression ratio of data obtained after compression is performed by using the former transform base is less than a compression ratio of data obtained after compression is performed by using the latter transform base. Therefore, the latter transform base may be used to perform coarse-grained data compression.

How the second device obtains the configuration information is not limited in this application. For example, the second device receives RRC signaling or medium access control (medium access control, MAC) layer signaling from the first device, where the RRC signaling or the MAC layer signaling includes the configuration information.

The transform base set may be cyclically configured, or may be non-cyclically configured. This is not limited in this application.

In this implementation, if the second information indicates a transform base, the second information may include one or more transform bases in Q transform bases, or the second information may include indexes of the one or more transform bases in the Q transform bases.

For example, the configuration information includes two transform base sets. A data type corresponding to one transform base set is CSI data, and a data type corresponding to the other transform base set is sensing data. For details, refer to Table 2.

Table 2

| Index of a transform base | Corresponding data type | Transform base |
|---|---|---|
| 000 | Sensing data | $(\theta, \varphi, r)=B(x, y, z)$, where $\theta =$ $$\varphi=arccos(x/\sqrt{x^2 + y^2}),$$ $$\arcsin(z/\sqrt{x^2 + y^2 + z^2})$$ , and $r =$ $$\sqrt{x^2 + y^2 + z^2}$$ |
| 001 | Sensing data | $$\emptyset=arccos(x/\sqrt{x^2 + y^2}), \text{ and } R = \sqrt{x^2 + y^2}$$ $(\emptyset, R, z)=B(x, y, z)$, where |
| 010 | CSI data | A transform base B is an $\mathbb{R}^{64\times1024}$ matrix, and indicates a value of each element in the matrix |
| 011 | CSI data | A transform base B is an $\mathbb{R}^{64\times512}$ matrix, and indicates a value of each element in the matrix |
| 100 | CSI data | $B_1$ and $B_2$, where $B_1$ is an $M_1 \times N_1$ matrix, and an element in an $m^{th}$ row and an $n^{th}$ column in the matrix $B_1$ is $b_{mn} = e^{-j2\pi mn/N1}$; and $B_2$ is an $M_2 \times N_2$ matrix, and an element in an $m^{th}$ row and an $n^{th}$ column in the matrix B is $b_{mn} = e^{-j2\pi mn/N2}$ |

It can be learned from Table 2 that, in this application, one index may correspond to one transform base, or one index may alternatively correspond to a plurality of transform bases. For example, the index 100 corresponds to two transform bases. This method is applicable to a scenario in which a plurality of transform bases need to be used, and can further reduce overheads for indicating the plurality of transform bases.

With reference to Table 2, the at least one piece of transform base indication information obtained by the second device may be shown in Table 3.

Table 3

| Data type (first information) | Transform base (second information) | Constraint relationship (third information) | Valid time (fourth information) |
|---|---|---|---|
| Sensing data | 001 | T=B(X) | 100 ms |
| CSI data | 100 | $T=B_1TB_2$ | 200 ms |

In Table 3, the second information in the transform base indication information may include indexes of one or more transform bases in a transform base set. This can flexibly change the transform base and also reduce signaling overheads for indicating the transform base.

In this application, if the transform base indication information does not include the second information, the transform base indication information may further include fifth information. The fifth information indicates that the second device generates one or more first transform bases based on a data type.

In this application, the first device may further update configured transform base indication information by using signaling.

For example, the first device is a network device, and the second device is a terminal device. The network device sends CTB configuration (config) signaling to the terminal device. The CTB configuration signaling includes a transform base B3 and a transform base B4. A data type corresponding to the transform base B3 is sensing data, and a data type corresponding to the transform base B4 is CSI data.

For example, the transform base $B3 \in \mathbb{R}^{M3 \times N3}$, where $B3 = \begin{bmatrix} b_{00} & \cdots & b_{0(N3-1)} \\ \cdots & \cdots & \cdots \\ b_{(M3-1)0} & \cdots & b_{(M3-1)(N3-1)} \end{bmatrix}$; and the

transform base $B4 \in \mathbb{R}^{M4 \times N4}$, where $B4 = \begin{bmatrix} b_{00} & \cdots & b_{0(N4-1)} \\ \cdots & \cdots & \cdots \\ b_{(M4-1)0} & \cdots & b_{(M4-1)(N4-1)} \end{bmatrix}$.

Further, if the network device needs to update a transform base of the sensing data, the network device may further send CTB update (update) signaling to the terminal device. The CTB update signaling includes a transform base B5. A data type corresponding to the transform base B5 is sensing data. In this way, the transform base B3 corresponding to the sensing data may be updated to the transform base B5.

For example, the transform base $B5 \in \mathbb{R}^{M5 \times N5}$, where $B5 = \begin{bmatrix} b_{00} & \cdots & b_{0(N5-1)} \\ \cdots & \cdots & \cdots \\ b_{(M5-1)0} & \cdots & b_{(M5-1)(N5-1)} \end{bmatrix}$.

In the foregoing manner, the network device can flexibly configure a transform base for the terminal device by using the CTB configuration signaling, and can further update the transform base for the terminal device in real time by using the CTB update signaling.

In this application, in an implementation, the valid time indicated by the fourth information may be a quantity of times of using a transform base. For example, in a real-time calculation scenario or another scenario, a transform base used for to-be-sent data each time may vary. Therefore, the transform base is used for only one time. The valid time indicated by the fourth information is one time, indicating that the transform base may be used for one time. The transform base may alternatively be used for a plurality of times until the transform base is updated. For example, the valid time indicated by the fourth information is five times, indicating that the transform base may be used for five times.

In an implementation, the valid time indicated by the fourth information may be usage duration of the transform base. For example, the transform base may be used for long time, and the valid time indicated by the fourth information is 1000 ms, indicating that the transform base may be used for 1000 ms.

In this application, if a transform base can be used for a plurality of times or for long time, a plurality of groups of data may be jointly compressed based on the transform base. For example, N pieces of data are obtained in N time periods, and the N pieces of data are $X_1, X_2, ..., and X_N$. N is an integer greater than 1. The N pieces of data are combined into data X. X may be represented as follows:

$$X = \begin{bmatrix} X_1 \\ \cdots \\ X_N \end{bmatrix}$$

Correspondingly, because a transform base B needs to be used for N times, it may be considered that there are N same transform bases B. In this case, the N same transform bases B are represented as follows:

$$\begin{bmatrix} B & \cdots & 0 \\ \vdots & \ddots & \vdots \\ 0 & \cdots & B \end{bmatrix}$$

If the constraint relationship is T=BX, data T obtained by jointly compressing N groups of data may be represented as follows:

$$T = \begin{bmatrix} T_1 \\ \cdots \\ T_N \end{bmatrix} = \begin{bmatrix} B & \cdots & 0 \\ \vdots & \ddots & \vdots \\ 0 & \cdots & B \end{bmatrix} \begin{bmatrix} X_1 \\ \cdots \\ X_N \end{bmatrix}$$

If the constraint relationship is T≈BX, data T obtained by jointly compressing N groups of data may be represented as follows:

$$T = \begin{bmatrix} T_1 \\ \cdots \\ T_N \end{bmatrix} \approx \begin{bmatrix} B & \cdots & 0 \\ \vdots & \ddots & \vdots \\ 0 & \cdots & B \end{bmatrix} \begin{bmatrix} X_1 \\ \cdots \\ X_N \end{bmatrix}$$

Further, quantization and element selection may be performed on T. For a specific process, refer to the following descriptions.

Jointly compressing the plurality of groups of data can reduce compression time and enhance data compression efficiency.

Step 303: The second device determines the second data based on the at least one first transform base and the first data.

In this application, because the at least one first transform base and the first data satisfy the constraint relationship, the second data may be determined based on the constraint relationship. For example, the constraint relationship is X=BT, the first data is X, and the first transform base is B. In this case, T may be determined based on the constraint relationship. T may be directly used as the second data, or data obtained after quantization and element selection are performed on T may be used as the second data.

In this application, the second data is data obtained after the first data is transformed, and may also be referred to as compressed data. A data amount of the second data is less than a data amount of the first data.

In this application, if a quantity of first transform bases is greater than 1, the at least one first transform base and the first data satisfy one constraint relationship, or may satisfy a plurality of constraint relationships. For example, the at least one first transform base includes a transform base $B_1$ and a transform base $B_2$, and the transform base $B_1$ and the transform base $B_2$ and the first data X may satisfy one constraint relationship, where the constraint relationship is $X=B_1TB_2$. In this case, the second data may be directly determined based on the constraint relationship.

In an implementation, if the at least one first transform base and the first data satisfy a plurality of constraint relationships, the second data may be determined based on the plurality of constraint relationships. In this case, the at least one first transform base is used in a cascading manner. For example, two constraint relationships are used as an example. The at least one first transform base includes a second transform base and a third transform base. In this case, third data may be determined based on the second transform base and the first data, where the second transform base and the first data satisfy a first constraint relationship. Then, the second data is determined based on the third transform base and the third data, where the third transform base and the third data satisfy a second constraint relationship.

For example, the at least one first transform base includes a transform base $B_1$ and a transform base $B_2$, and may satisfy two constraint relationships with the first data X. For example, the two constraint relationships are $X=B_1T_1$ and $T_2=B_2T_1$. In this case, $T_2$ may be determined based on the two constraint relationships, and then the second data is determined based on $T_2$. In this case, the transform base $B_1$ and the transform base $B_2$ are used in the cascading manner.

Similarly, if the at least one first transform base and the first data satisfy three or more constraint relationships, for details about how to determine the second data, refer to the foregoing descriptions.

In an implementation, the at least one first transform base may be used in parallel. It is assumed that to-be-compressed first data X is CSI data. SVD decomposition may be performed on the first data X. $X = U\Sigma V^T$, where it is assumed that $X_1=U$ and $X_2=V$. In this case, a transform base $B_1$ and a transform base $B_2$ corresponding to the first data X are obtained. $X_1$ is transformed based on $B_1$, $X_1 \approx B_1T_1$, and then $T_1$ is quantized to obtain $Y_1$. In parallel, $X_2$ is transformed based on $B_2$, $X_2 \approx B_2T_2$, and then $T_2$ is quantized to obtain $Y_2$. The second data may be determined based on $Y_1$ and $Y_2$. In this case, the transform base $B_1$ and the transform base $B_2$ are used in parallel.

In this application, if the to-be-compressed data includes a plurality of types of data, the plurality of types of data may be jointly encoded, to obtain the second data. Specifically, it is assumed that the to-be-compressed data further includes the fourth data, the data type of the fourth data is the second data type, and the second data type is different from the first data type. The second device may determine at least one fourth transform base based on the second data type. For a specific process, refer to the descriptions in step 302. Details are not described herein again.

The second device may determine fifth data based on the at least one first transform base and the first data, and determine sixth data based on the at least one fourth transform base and the fourth data. Then, the second device may determine the second data based on the fifth data and the sixth data.

For example, it is assumed that the to-be-compressed data includes K types of data, and K is greater than 1. For example, the K types of data include sensing data, CSI data, and the like. The K types of data are respectively represented by $X_1, X_2, ...,$ and $X_K$, and transform bases corresponding to the K types of data are respectively represented by $B_1, B_2, ...,$ and $B_K$.

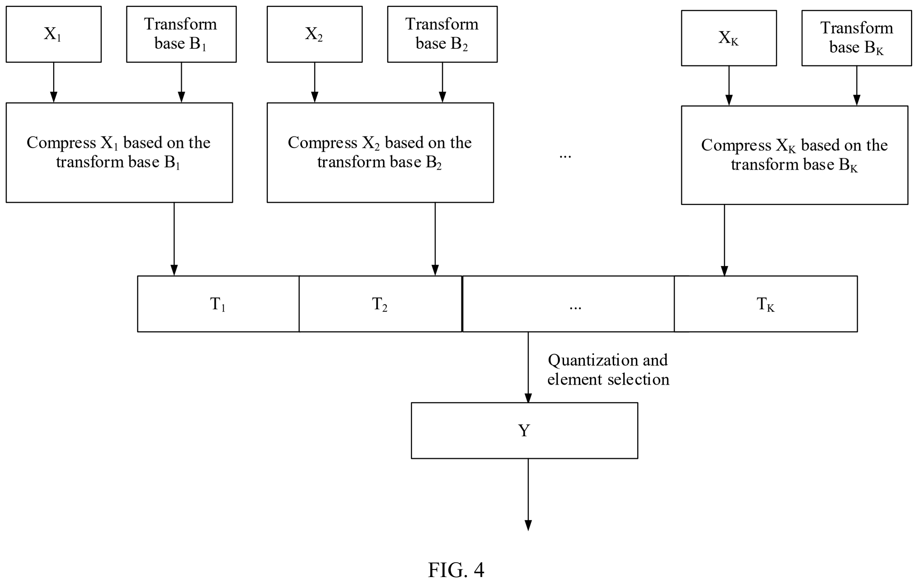

In a first implementation, the K types of data may be separately encoded, and then combined and sent. For example, as shown in FIG. 4, for data $X_1$, $X_1$ is compressed based on the transform base $B_1$ to obtain $T_1$; for data $X_2$, $X_2$ is compressed based on the transform base $B_2$ to obtain $T_2$; ..., for data $X_K$, $X_K$ is compressed based on the transform base $B_K$ to obtain $Y_K$. In total, K pieces of compressed data: $T_1, T_2, ...,$ and $T_K$ are obtained. $T_1, T_2, ...,$ and $T_K$ may be combined into T. The second device may directly use the data T as the second data, or may perform quantization and element selection on the data T to obtain data Y, and then send the data Y.

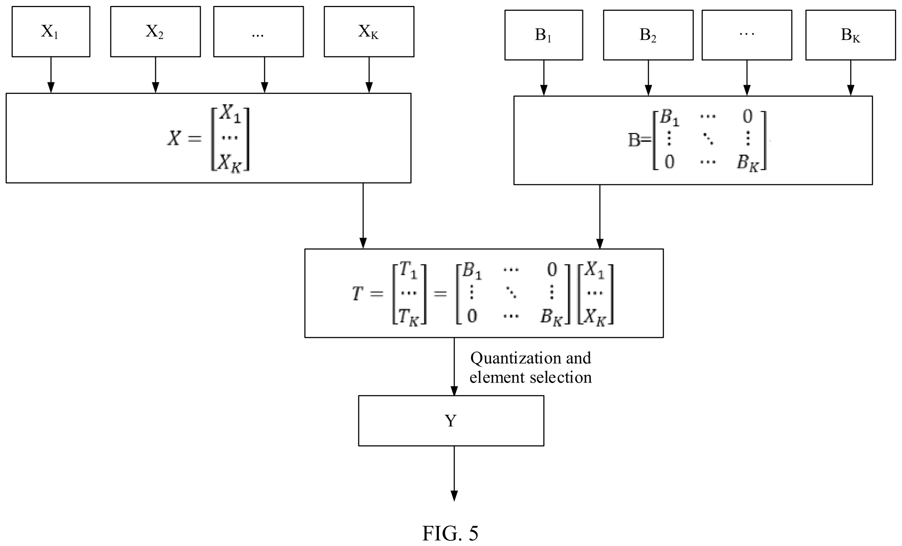

In a second implementation, the K types of data may be jointly encoded. For example, as shown in FIG. 5, it is assumed that each type of data satisfies the constraint relationship T=BX, the K types of data may be combined into new data X, and the K transform bases are combined into a new transform base B. In this case, X and B may be respectively represented as follows:

$$X = \begin{bmatrix} X_1 \\ \cdots \\ X_K \end{bmatrix}; \text{ and } B = \begin{bmatrix} B_1 & \cdots & 0 \\ \vdots & \ddots & \vdots \\ 0 & \cdots & B_K \end{bmatrix}$$

T obtained after X is transformed based on the transform base B satisfies the following:

$$T = \begin{bmatrix} T_1 \\ \cdots \\ T_K \end{bmatrix} = \begin{bmatrix} B_1 & \cdots & 0 \\ \vdots & \ddots & \vdots \\ 0 & \cdots & B_K \end{bmatrix} \begin{bmatrix} X_1 \\ \cdots \\ X_K \end{bmatrix}$$

$T_i=B_iX_i$, where i=1, ..., or K. The second device may directly use the data T as the second data; or may perform quantization and element selection on the data T to obtain data Y, and then send the data Y.

In this application, before sending the second data, the second device may further perform quantization and element selection on the second data. The following separately provides descriptions.

For ease of description, the following uses data before quantization and element selection are performed on the second data as eighth data. The eighth data may be in a form of a vector, a matrix, or the like, and the eighth data includes at least two elements.

In an implementation, each element in the eighth data may be uniformly quantized or unevenly quantized. This is not limited in this application.

Information such as a quantization manner and a quantization parameter of the eighth data may be implicitly agreed on, for example, agreed on based on the data type; or may be explicitly indicated, for example, quantization indication information is added to the transform base indication information or other signaling. In this application, different quantization levels may be further used for different devices and different data types.

For example, the transform base indication information carries sixth information. As shown in Table 4, q=5 indicates that data obtained after the sensing data is processed by using a transform base is quantized by using 5 bits, in other words, a quantization level is 5. q={4, 3, 2} indicates that data obtained after the CSI data is processed by using a transform base is quantized by using 2, 3, or 4 bits, in other words, a quantization level is 2, 3, or 4, or a quantization set is configured.

With reference to Table 3, the at least one piece of transform base indication information may be shown in Table 4.

Table 4

| Data type (first information) | Transform base (second information) | Constraint relationship (third information) | Valid time (fourth information) | Sixth information |
|---|---|---|---|---|
| Sensing data | 001 | T=B(X) | 100 ms | q=5 |
| CSI data | 100 | $T=B_1TB_2$ | 200 ms | q={4, 3, 2} |

In this application, different quantization levels may be further used for data in different regions and at different time (for example, a quantization configuration is added to transform base indication information, or the second device determines and reports a quantization parameter, or a quantization configuration is agreed on in a protocol).

Details about how to use different quantization levels for the data in different regions are as follows. For example, the eighth data is a 4×4 matrix, and includes a plurality of elements. An element in a first region in the eighth data may be quantized by using a first quantization level, and an element in a second region in the eighth data may be quantized by using a second quantization level. For example, the first region includes elements in a first row and a second row of the eighth data, and the second region includes elements in a third row and a fourth row of the eighth data.

Details about how to use different quantization levels for the data at different time are as follows. For example, the second device obtains data X1 at time t1 by using a transform base, and obtains data X2 at time t2 by using a transform base. The data X1 may be quantized by using the first quantization level, and the data X2 may be quantized by using the second quantization level.

In this application, it is assumed that the eighth data includes at least two elements, and element selection means selecting at least one element from the at least two elements in the eighth data. The second device may determine the second data based on the selected at least one element.

In an implementation, element selection may be performed based on a threshold. For example, at least one element greater than the threshold is selected from the at least two elements in the eighth data. Herein, greater than the threshold may mean that a value of the element is greater than the threshold, or may mean that an absolute value of the element is greater than the threshold. In this implementation, element selection may be performed before quantization. To be specific, element selection is first performed based on the threshold, to obtain the at least one element greater than the threshold, and then quantization is performed on the at least one element. Alternatively, in this implementation, quantization may be performed before element selection. To be specific, quantization is first performed on the at least two elements in the eighth data, and then a quantized element greater than the threshold is selected.

The threshold may be synchronized between a transmit end and a receive end through network configuration, indication by the first device, protocol agreement, or the like.

In an implementation, element selection may be performed based on a quantity of elements. For example, the quantity of elements is P, where P is an integer greater than 0. In this implementation, P elements with largest values or absolute values are selected from the at least two elements in the eighth data.

The quantity P of elements may be synchronized between a transmit end and a receive end through network configuration, indication by the first device, protocol agreement, or the like.

In an implementation, element selection may be performed based on a preset location. For example, if the eighth data is a matrix, an element at a preset location in the eighth data may be used as the selected at least one element. The preset location may be synchronized between a transmit end and a receive end through network configuration, indication by the first device, protocol agreement, or the like.

Step 304: The second device sends the second data to the first device.

Correspondingly, the first device receives the second data from the second device.

The first device may be a terminal device or a network device. This is not limited in this application.

In an implementation, before sending the second data, the second device may perform other processing, for example, sequentially perform processing such as channel coding, modulation, resource mapping, and antenna mapping on the second data, and finally transmit the second data through an air interface.

In an implementation, the second device may further send first indication information to the first device. The first indication information indicates the at least one first transform base. For example, if the second device determines, in real time based on the data type, the at least one first transform base used for data compression, the second device may send the at least one first transform base to the receive end. The at least one first transform base may be sent with compressed data, or may be separately sent in a longer cycle. Alternatively, the at least one first transform base may also be compressed and then sent. For example, the at least one first transform base is compressed in a manner of quantization, entropy encoding, or the like, to save transmission resources. This is not limited in this application.

In an implementation, the second device may further send second indication information to the first device. The second indication information indicates location information of each element in the second data. Specifically, if the second data is data obtained by performing element selection on the eighth data, the second indication information may indicate, in the eighth data, location information of each element in the second data.

In this implementation, the location information of each element in the second data is explicitly indicated by using the second indication information. For example, the second indication information is represented by using a bitmap (bitmap) (for example, a bit being 1 indicates that the element is selected, and a bit being 0 indicates that the element is not selected), or the second indication information is an index (a one-dimensional or two-dimensional index) of an element location.

For example, the eighth data is a 5×4 matrix. It is assumed that Table 5 is a diagram of a location of a matrix corresponding to the eighth data. In Table 5, a bit being 1 indicates that an element at the location is selected, and a bit being 0 indicates that an element at the location is not selected.

Table 5

| | | | |
|---|---|---|---|
| 1 | 1 | 1 | 1 |
| 1 | 1 | 0 | 0 |
| 0 | 0 | 1 | 1 |
| 0 | 0 | 0 | 0 |
| 1 | 1 | 1 | 0 |

If the bitmap indicates location information of the selected element, and each element is indicated in a sequence of rows before columns in the matrix, the bitmap may be 1111, 1100, 0011, 0000, or 1110.

Correspondingly, the first device may obtain a decoded value (or a reconstructed value) of the second data based on the location information of each element in the second data. A value of an element that is not selected is set to 0.

In this application, if the location information of the selected element can be implicitly known, the second indication information does not need to be sent. For example, SVD decomposition of $X = B_1TB_2 = U\Sigma V^T$ is performed on data X, where U and V are a left singular matrix and a right singular matrix, respectively. $\Sigma$ is a singular value matrix. Only values that are not 0 exist on a diagonal. These values are called singular values. If singular values on the diagonal of $\Sigma$ are arranged in descending order, when it is agreed that two largest elements in T=$\Sigma$ are selected, it is implicitly known that the two largest elements are the first two values on the diagonal. In this case, the second indication information does not need to be sent.

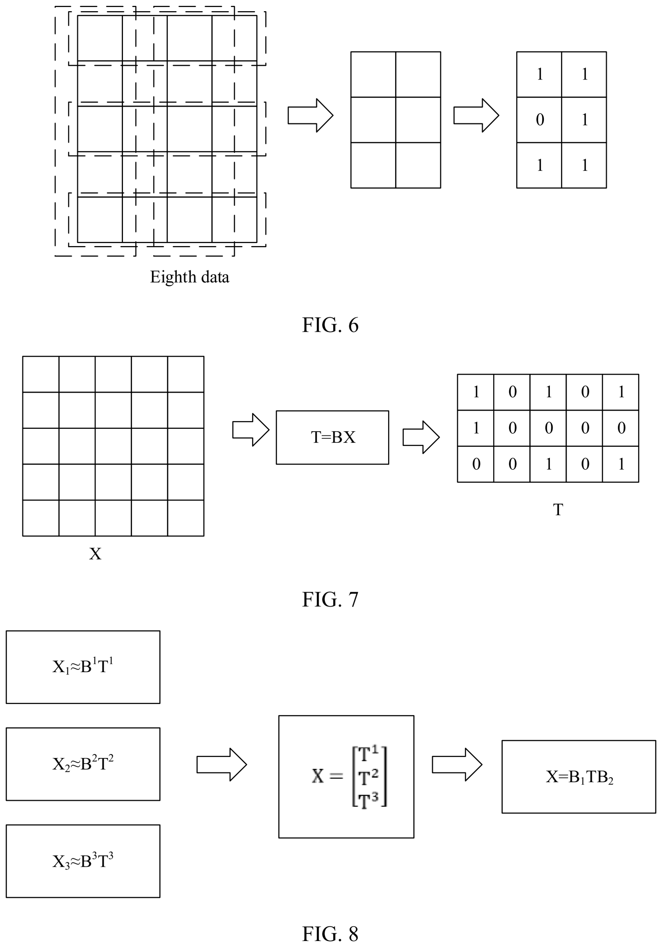

In this application, in an element selection process, elements may be further selected from some rows and columns in the eighth data. For example, some rows and columns in the matrix are first selected, and then elements in the rows and columns are further selected. In this way, a range of the selected elements can be narrowed down, and location indication overheads of the selected elements can be reduced. For example, as shown in FIG. 6, the eighth data is a 5×4 matrix. It may be agreed in advance that elements are selected from rows 1, 3, and 5 and columns 1 and 3 in the matrix, that is, rows and columns marked by dashed-line boxes in the figure. In this case, elements in the rows 1, 3, and 5 and the columns 1 and 3 may form a 3×2 matrix. Then, at least one element may be selected from the matrix based on a threshold. In the figure, 1 indicates that an element at the location is selected, and 0 indicates that an element at the location is not selected. There are five elements whose locations are 1. Finally, the five elements are selected.

Step 305: The first device restores seventh data from the second data based on the at least one first transform base.

The first device may determine the at least one first transform base based on the first data type of the second data. For a specific process, refer to the descriptions in step 302. Details are not described herein again.

In this application, the process in which the first device restores the seventh data from the second data may be an inverse process of determining the second data. For example, a constraint relationship between the first data X and the first transform base B is T=BX, and the seventh data determined by the first device based on the second data is a decoded value (or a reconstructed value) X' of X: X'=B$^{-1}$T', where B$^{-1}$ may be an inverse matrix or a pseudo-inverse matrix of B.

For example, a constraint relationship between the first data X and the first transform base B is T=XB, and the seventh data determined by the first device based on the second data is a decoded value (or a reconstructed value) X' of X: X'=T'B$^{-1}$, where B$^{-1}$ may be an inverse matrix or a pseudo-inverse matrix of B.

For example, a constraint relationship between the first data X and the first transform base B is T=B$_1$XB$_2$, and the seventh data determined by the first device based on the second data is a decoded value (or a reconstructed value) X' of X:

X'=B$^{-1}$$_1$T'B$^{-1}$$_2$, where $B_1^{-1}$ may be an inverse matrix or a pseudo-inverse matrix of B$_1$, and $B_2^{-1}$ may be an inverse matrix or a pseudo-inverse matrix of B$_2$.

For example, a constraint relationship between the first data X and the first transform base B is X≈BT or X=BT, and the seventh data determined by the first device based on the second data is a decoded value (or a reconstructed value) X' of X: X'=BT'.

For example, a constraint relationship between the first data X and the first transform base B is X=B$_1$TB$_2$ or X≈B$_1$TB$_2$, and the seventh data determined by the first device based on the second data is a decoded value (or a reconstructed value) X' of X: X'=B$_1$T'B$_2$.

T' is the second data. If the second device performs quantization and element selection on the second data before sending the second data, T' is a decoded value (or a reconstructed value) of T. If the second device does not perform quantization and element selection on the second data before sending the second data, T' may be the same as T.

For example, a constraint relationship between the first data X and the first transform base B is T=B(X), and the first device may obtain a decoded value (or a reconstructed value) X' of X: $X' = \overline{B}(T)$. $\overline{B}(T)$ is an inverse function of $B(X)$.

If $T = (\theta, \varphi, r)$, $X = (x,y,z)$, a function transform base B(X) is represented as $(\theta, \varphi, r) = B(x, y, z)$, where

$$\theta = \arcsin(z/\sqrt{x^2 + y^2 + z^2}) \quad, \quad \varphi = arccos(x/\sqrt{x^2 + y^2}) \text{ , and } \quad r = \sqrt{x^2 + y^2 + z^2} \text{ . An inverse function } \overline{B}(T) \text{ of}$$

B(X) may be represented as $(x, y, z) = \overline{B}(\theta, \varphi, r)$, where $\quad z = r \times \sin(\theta), y = \sqrt{r^2 - z^2} \times \cos(\varphi)$ , and

$x = \sqrt{r^2 - y^2 - z^2}$ .

If T=(Ø, R, z), X=(x, y, z), a function transform base B(X) is represented as (Ø, R, z) = B(x, y, z), where

$\emptyset = arccos(x/\sqrt{x^2 + y^2})$ and $R = \sqrt{x^2 + y^2}$ . An inverse function $\overline{B}(T)$ of B(X) may be represented as $(x, y, z) = \overline{B}(Ø, R,$

z), where x = $R \times$ cos(Ø) and $y = \sqrt{R^2 - x^2}$ .

In an implementation, if the second device compresses the first data in a cascading manner by using the at least one first transform base to obtain the second data, the first device may restore the second data based on the at least one first transform base in the cascading manner. For example, the at least one first transform base includes a second

transform base $B_1$ and a third transform base $B_2$, and third data $T_1$ is determined based on the second transform base $B_1$ and the first data, where $X=B_1T_1$ is satisfied, and X is the first data. The second data $T_2$ is determined based on the third transform base $B_2$ and the third data, where $T_2=T_1B_2$ is satisfied. In this case, the first device may determine ninth data $X_1'$ based on the third transform base and the second data: $X_1'=T_2B_2^{-1}$, and determine the seventh data $X_2'$ based on the second transform base $B_1$ and the ninth data: $X_2'=B_1X_1'$, where $B_2^{-1}$ may be an inverse matrix or a pseudo-inverse matrix of the third transform base $B_2$.

In an implementation, if the second device compresses the first data and fourth data in a parallel manner by using the transform base to obtain the second data, the first device may separately restore compressed data of the first data and the fourth data.

For example, the second device may determine fifth data $T_1$ based on the at least one first transform base $B_1$ and the first data $X_1$, and determine sixth data $T_2$ based on at least one fourth transform base $B_2$ and fourth data $X_2$, where $X_1=B_1T_1$, and $X_2=B_2T_2$. Then, the second device may determine the second data based on the fifth data and the sixth data, for example, $T=[T_1T_2]$. Correspondingly, the first device may restore tenth data $X_1'$ from the fifth data $T_1$ based on the at least one first transform base $B_1$, and restore eleventh data $X_2'$ from the sixth data $T_2$ based on the at least one fourth transform base $B_2$, where $X_1'=B_1T_1$ and $X_2'=B_2T_2$. The tenth data $X_1'$ is a decoded value (or a reconstructed value) of the first data; and the eleventh data $X_2'$ is a decoded value (or a reconstructed value) of the fourth data.

The foregoing descriptions are merely examples. Details about how the first device restores the seventh data from the second data are not limited in this application.

According to the method provided in this application, a unified compression framework based on a transform base is proposed for the to-be-compressed data. The transform base can be flexibly determined based on a data type of the data, and information such as a constraint relationship between the transform base and the data, and valid time can be further determined. This ensures compression performance, provides the unified compression framework and a simple configuration procedure, enhances compression efficiency, and reduces data transmission overheads.

A network device may send transform base indication information to a terminal device. The transform base indication information may be shown in Table 6.

Table 6

| Data type (first information) | Constraint relationship (third information) | Valid time (fourth information) | Fifth information | Sixth information | Seventh information |
|---|---|---|---|---|---|
| Sensing data | T=BX | One time | Generate a first transform base based on a data type | q=5 | Six largest elements |

It can be learned from Table 6 that a data type indicated by the transform base indication information configured by the network device is the sensing data, a transform base is generated by the terminal device in real time, a constraint relationship is T=BX, transformed data is quantized by using 5 bits, and then the six largest elements are selected.

When obtaining the sensing data, the terminal device may determine information such as the transform base based on the transform base indication information configured by the network device. It is assumed that the sensing data X obtained by the terminal device is a 5×5 matrix. The terminal device generates a 3×5 matrix as a first transform base B. As shown in FIG. 7, the terminal device may obtain a 3×5 matrix T based on the constraint relationship indicated by the transform base indication information. Data T obtained by transforming the sensing data X based on the transform base is a matrix that is more sparse than X, so that the sensing data X is compressed.

The terminal device quantizes each element in T by using 5 bits, to obtain 15 quantized elements. Then, six (largest) elements are selected from the 15 quantized elements. For example, elements corresponding to locations in which bits are 1 in the figure are the selected elements.

Further, the terminal device sends first indication information, where the first indication information indicates the transform base B. The transform base B may be further compressed, for example, through quantization, entropy encoding, or the like, to reduce transmission overheads. The entropy encoding includes arithmetic encoding, Huffman encoding, run-length encoding, Lempel-Ziv-Markov chain algorithm (Lempel-Ziv-Markov chain algorithm, LZMA), and the like. This is not limited in this application.

The terminal device may further send second indication information. The second indication information may be represented by using a bitmap: 10101100000101, or the second indication information may be directly represented by using indexes of the selected elements. For example, the second indication information may be represented as 0, 2, 4, 5, 12, 14, or 1, 3, 5, 6, 13, 15. The second indication information may be further entropy encoded, to reduce indication overheads.

It should be noted that if a receive end and a transmit end have known dimension information of T in a pre-configuration manner or a protocol agreement manner, a size of a bitmap corresponding to location information of the selected elements or a range of indexes is known. In this case, the dimension information of T does not need to be separately indicated. Otherwise, the terminal device further needs to indicate the dimension information of T or dimension information of the bitmap.

The terminal device further sends values of the selected elements. The values of the elements may be further entropy encoded, to reduce indication overheads. In addition, in this example, the value of the element is a quantized value. In some scenarios, the element may not be quantized, for example, may be a floating point number or a complex number.

A network device may send transform base indication information to a terminal device. The transform base indication information may be shown in Table 7.

Table 7

| Data type (first information) | Constraint relationship (third information) | Valid time (fourth information) | Fifth information | Sixth information | Seventh information |
|---|---|---|---|---|---|
| Sensing data | $X \approx BT$ | 3 times | Generate a first transform base based on a data type | / | / |
| Sensing data | $X = B_1 T B_2$ | One time | Generate a first transform base based on a data type | q=5 | Two largest elements |

It can be learned from Table 7 that the network device configures two pieces of transform base indication information for the sensing data. It is assumed that the network device indicates the terminal device to first use a transform base indication information in the first row and then use a transform base indication information in the second row in a cascading manner.

Correspondingly, the terminal device obtains sensing data in three time periods, which are $X_1$, $X_2$, and $X_3$. The terminal device may obtain $X_1 \approx B^1 T^1$, $X_2 \approx B^2 T^2$, and $X_3 \approx B^3 T^3$ based on the first transform base indication information.

As shown in FIG. 8, the terminal device may combine $T^1$, $T^2$, and $T^3$ into new data X. X satisfies the following:

$$X = \begin{bmatrix} T^1 \\ T^2 \\ T^3 \end{bmatrix}$$

The terminal device performs SVD decomposition on X to obtain $B_1$, $B_2$, and T, that is, $X = B_1 T B_2 = U \Sigma V^T$. $B_1 = U$, and indicates a left singular matrix of X; $B_2 = V$, and indicates a right singular matrix of X; and $T = \Sigma$, and indicates a singular value matrix of X. The terminal device selects two largest elements from T as data sent to the network device.

The terminal device further indicates the following information to the network device: transform bases $B_1$, $B_2$, and $B^3$; and

location information of the two elements selected from T; and information about $B_1$ and $B_2$.

If $B^1$, $B^2$, and $B^3$ are the same, only one of them needs to be indicated. In an SVD scenario, singular values on a diagonal line in T are sorted in descending order, and the first two values on the diagonal line can be implicitly determined. In this case, location information of the two elements may not be indicated.

A network device may send configuration information to a terminal device. The configuration information includes a transform base set, the transform base set includes two transform bases, and a data type corresponding to the transform base set is sensing data. For details, refer to Table 8.

Table 8

| Index of a transform base | Corresponding data type | Transform base |
|---|---|---|
| 0 | Sensing data | $(\theta, \varphi, r) = B(x, y, z)$, where $\theta = \arcsin(z/\sqrt{x^2 + y^2 + z^2})$, $\varphi = arccos(x/\sqrt{x^2 + y^2})$, and $r = \sqrt{x^2 + y^2 + z^2}$ |

(continued)

| Index of a transform base | Corresponding data type | Transform base |
|---|---|---|
| 1 | Sensing data | $\emptyset = \arccos(x/\sqrt{x^2+y^2})$ <br><br> $(\emptyset, R, z) = B(x, y, z)$, where and $R = \sqrt{x^2+y^2}$ |

Further, the network device further configures information such as a transform base. Transform base indication information may be shown in Table 9.

Table 9

| Data type (first information) | Transform base (second information) | Constraint relationship (third information) | Sixth information |
|---|---|---|---|
| Sensing data | 0 | T=B(X) | A quantization level of $\theta$ is 5; a quantization level of $\varphi$ is 5; and a quantization level of r is 8 |

It is assumed that to-be-compressed data X=(x, y, z) obtained by the terminal device is Cartesian coordinates of a plurality of points in the sensing data. Based on the transform base indication information configured by the network device, the terminal device may transform data X based on the transform base corresponding to index 0 in the transform base indication information in Table 8. A calculation manner is T=($\theta$, $\varphi$, r)=B(x, y, z). The terminal device may obtain values of a plurality of groups of ($\theta$, $\varphi$, r).

The terminal device quantizes $\theta$, $\varphi$, and r in the data T=($\theta$, $\varphi$, r) by respectively using 5 bits, 5 bits, and 8 bits.

Further, the terminal device sends compressed data, namely, quantized data T.

In an implementation, the terminal device directly sends a plurality of quantized $\theta$, $\varphi$, and r, or may combine a plurality of groups ($\theta$, $\varphi$, and r) to perform entropy encoding and then send the processed data, or may separately combine a plurality of $\theta$, a plurality of $\varphi$, and a plurality of r to perform entropy encoding and then send the processed data.

In another implementation, the terminal device may form a two-dimensional matrix by using $\theta$ and $\varphi$ as horizontal and vertical coordinates (an x-axis and a y-axis), and fill each element in the two-dimensional matrix with corresponding r. After r is quantized, many values are 0, and only non-zero values may be sent to the receive end. In this case, location information of the non-zero values, namely, location information of selected elements, may alternatively be indicated in a manner of a bitmap or an index.

For example, the two-dimensional matrix formed by the terminal device by using $\theta$ and $\varphi$ as the horizontal and vertical coordinates is shown in Table 10. A horizontal axis in Table 10 corresponds to $\varphi$, and a vertical axis in Table 10 corresponds to $\theta$. There is a location diagram of a matrix corresponding to seventh data. Each value in Table 10 is a value corresponding to r, and each value herein is a quantized value.

Table 10

| | | | |
|---|---|---|---|
| 3 | 57 | 0 | 31 |
| 16 | 0 | 0 | 0 |
| 0 | 0 | 0 | 0 |
| 61 | 0 | 0 | 110 |

The terminal device may send only values greater than 0 in Table 10, and indicate location information of the values greater than 0. For example, the location information may be indicated by using a bitmap. In an order of rows before columns, a bitmap corresponding to Table 10 may be 1101 1000 0000 1001.

In a quantization process, $\theta$, $\varphi$, or r may be directly quantized, or $\theta$, $\varphi$, or r may be shifted to a preset value range and then quantized, to reduce a quantization loss at a same quantization bit. In this case, the preset value range may be further indicated to the receive end.

A network device may send configuration information to a terminal device. The configuration information includes a transform base set, the transform base set includes three transform bases, and a data type corresponding to the transform base set is CSI data. For details, refer to Table 11.

Table 11

| Index of a transform base | Corresponding data type | Transform base |
|---|---|---|
| 00 | CSI data | A transform base B is an $\mathbb{R}^{64\times1024}$ matrix, and indicates a value of each element in the matrix |
| 01 | CSI data | A transform base B is an $\mathbb{R}^{64\times512}$ matrix, and indicates a value of each element in the matrix |
| 10 | CSI data | $B_1$ and $B_2$, where $B_1$ is an $M_1\times N_1$ matrix, and an element in an $m^{th}$ row and an $n^{th}$ column in the matrix $B_1$ is $b_{mn} = e^{-j2\pi mn/N1}$ ; and $B_2$ is an $M_2\times N_2$ matrix, and an element in an $m^{th}$ row and an $n^{th}$ column in the matrix B is $b_{mn} = e^{-2\pi mn/N2}$ |

Further, the network device sends transform base indication information to the terminal device. For example, the transform base indication information may be shown in Table 12.

Table 12

| Data type (first information) | Transform base (second information) | Constraint relationship (third information) | Seventh information |
|---|---|---|---|
| CSI data | 10 | $T=B_1XB_2$ | Select elements in three rows and two columns, and then further select five elements in the selected elements |

It is assumed that to-be-compressed data X obtained by the terminal device is the CSI data. Based on the transform base indication information configured by the network device, the terminal device may determine transform bases as $B_1$ and $B_2$ based on index 10 in the transform base indication information in Table 11.

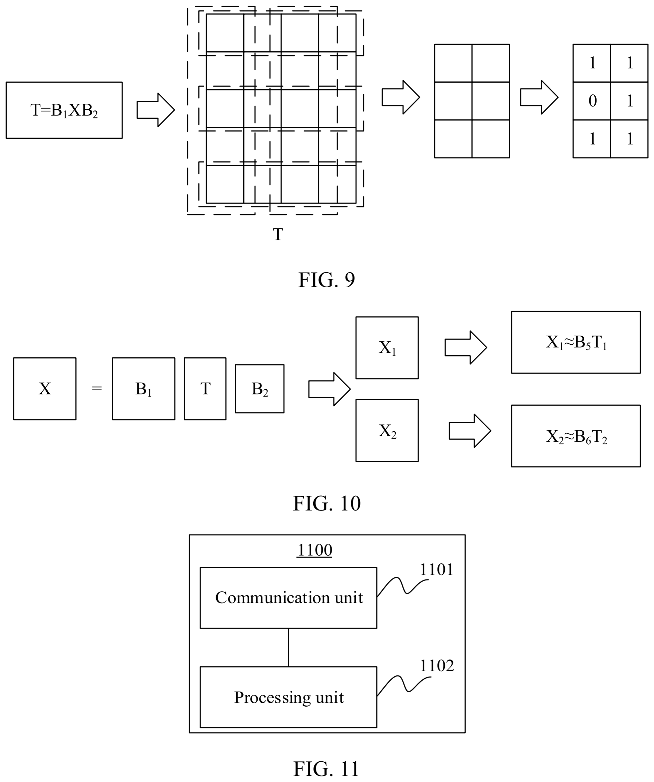

The terminal device determines data T based on a constraint relationship $T=B_1XB_2$. As shown in FIG. 9, it is assumed that the data T is a $5\times4$ matrix. In this case, elements in three rows and two columns may be selected from the matrix, and then five elements in the selected elements are further selected. For example, a row and a column with highest energy, a largest absolute value sum, or a largest square sum are selected. It is assumed that elements are selected from rows 1, 3, and 5 and columns 1 and 3 in the matrix, that is, rows and columns marked by dashed-line boxes in the figure. In this case, elements in the rows 1, 3, and 5 and the columns 1 and 3 may form a $3\times2$ matrix. Then, five largest elements may be selected from the matrix. In the figure, 1 indicates that an element at the location is selected, and 0 indicates that an element at the location is not selected. There are five elements whose locations are 1. Finally, the five elements are selected.

The terminal device may send values of the selected five elements. The values of the elements may be further quantized and entropy encoded, to reduce indication overheads. The terminal device may further send the following information:

row and column information of a selected element; and
location information of the selected element, where the location information indicates a location of the element in a matrix that is obtained after three rows and two columns are selected from the data T, and the location information may be represented by using a bitmap or an index; and the location information may be further entropy encoded, to reduce indication overheads.

A network device may send configuration information to a terminal device. The configuration information includes a transform base set, the transform base set includes three transform bases, and a data type corresponding to the transform base set is CSI data. For details, refer to Table 13.

Table 13

| Index of a transform base | Corresponding data type | Transform base |
|---|---|---|
| 00 | CSI data | A transform base B is an $\mathbb{R}^{64\times1024}$ matrix, and indicates a value of each element in the matrix |

(continued)

| Index of a transform base | Corresponding data type | Transform base |
|---|---|---|
| 01 | CSI data | A transform base B is an $\mathbb{R}^{64 \times 512}$ matrix, and indicates a value of each element in the matrix |
| 10 | CSI data | $B_3$ and $B_4$, where $B_3$ is an $M_1 \times N_1$ matrix, and an element in an $m^{th}$ row and an $n^{th}$ column in the matrix $B_3$ is $b_{mn} = e^{-j2\pi mn/N1}$; and $B_4$ is an $M_2 \times N_2$ matrix, and an element in an $m^{th}$ row and an $n^{th}$ column in the matrix $B_4$ is $b_{mn} = e^{-j2\pi mnjN2}$ |

Further, the network device sends transform base indication information to the terminal device. For example, the transform base indication information may be shown in Table 14.

Table 14

| Data type (first information) | Transform base (second information) | Constraint relationship (third information) | Valid time (fourth information) | Fifth information | Seventh information |
|---|---|---|---|---|---|
| CSI data | / | $X=B_1TB_2$ | One time | Generate a transform base based on a data type | Select two largest elements |
| CSI data | 00 and 01 | $X \approx BT$ | 100 ms | / | Select two largest elements |

The network device indicates the terminal device to first use first transform base indication information and then use second transform base indication information.

It is assumed that to-be-compressed data X obtained by the terminal device is the CSI data. The terminal device performs SVD decomposition on X based on a constraint relationship $X=B_1TB_2$ in the first transform base indication information, to obtain $X = U\Sigma V^T = B_1TB_2$, that is, $B_1=U$, $B_2=V$, and $T=\Sigma$. The terminal device selects two largest elements from T. In an SVD scenario, singular values on a diagonal line in T are sorted in descending order, and it can be implicitly determined that the two largest elements are the first two values on the diagonal line in T. Because only the first two pieces of coefficient information are selected from T, elements in the first two columns and the first two rows are also correspondingly selected from $B_1$ and $B_2$.

As shown in FIG. 10, the terminal device uses elements in the first two columns in $B_1$ as $X_1$, uses elements in the first two rows in $B_2$ as $X_2$, and transform $X_1$ and $X_2$ by using the second transform base indication information. A constraint relationship $X \approx BT$, namely, $X_1 \approx B_5T_1$ and $X_2 \approx B_6T_2$, is used for both $X_1$ and $X_2$. A transform base $B_5$ is a transform base corresponding to index 00 in Table 13, and a transform base $B_6$ is a transform base corresponding to index 01 in Table 13. The terminal device selects two largest elements from $T_1$ and $T_2$, respectively.

The terminal device may send values of a total of six elements: the two largest elements selected from T, the two largest elements selected from $T_1$, and the two largest elements selected from $T_2$. The values of the elements may be further quantized and entropy encoded, to reduce indication overheads.

The terminal device may further send the following information: location information of elements selected from $T_1$ and $T_2$, where the location information may be represented by using a bitmap or an index; and the location information may be further entropy encoded, to reduce indication overheads.

Based on the foregoing embodiments, an embodiment of this application further provides a communication apparatus. As shown in FIG. 11, a communication apparatus 1100 may include a communication unit 1101 and a processing unit 1102. The communication unit 1101 may be configured to receive and send information, and the like. The processing unit 1102 may control and manage actions of the communication apparatus 1100. The processing unit 1102 may further control operations performed by the communication unit 1101.

For example, the communication apparatus 1100 may be the second device in the foregoing embodiments, a processor in the second device, a chip, a chip system, a functional module, or the like. Alternatively, the communication apparatus 1100 may be the first device in the foregoing embodiments, a processor in the first device, a chip, a chip system, a functional module, or the like.

In an embodiment, when the communication apparatus 1100 is configured to implement a function of the second device in the foregoing embodiments, the following may be included.

The communication unit is configured to obtain to-be-compressed data, where the to-be-compressed data includes first data.

The processing unit is configured to: determine at least one first transform base based on a first data type of the first data, and determine second data based on the at least one first transform base and the first data.

The communication unit is configured to send the second data to the first device.

In an embodiment, the processing unit is specifically configured to:

determine, from at least one piece of transform base indication information, first transform base indication information corresponding to the first data type, and use a transform base indicated by the first transform base indication information as the at least one first transform base.

In an embodiment, the communication unit is further configured to:

receive the at least one piece of transform base indication information; or
the at least one piece of transform base indication information is preconfigured; or
the at least one piece of transform base indication information is generated in real time.

In an embodiment, the transform base indication information includes at least one of the following:

first information, indicating a data type;
second information, indicating one or more transform bases;
third information, indicating a constraint relationship between data and the one or more transform bases indicated by the second information; and
fourth information, indicating valid time of the one or more transform bases indicated by the second information.

In an embodiment, the communication unit is further configured to:

receive configuration information, where the configuration information indicates a transform base set, the transform base set includes Q transform bases, and Q is an integer greater than 0.

In an embodiment, the configuration information further indicates a correspondence between a data type and a transform base set.

In an embodiment, that the second information indicates the transform bases includes:

the second information includes one or more transform bases in the Q transform bases, or the second information includes indexes of the one or more transform bases in the Q transform bases.

In an embodiment, the at least one first transform base and the first data satisfy any one of the following constraint relationships:

$$X=BT;\ X{\approx}BT;\ T=BX;\ T=XB;\ X=B_1TB_2;\ X{\approx}B_1TB_2;\ \text{and}\ T=B(X)$$

X indicates the first data, and X may be a vector or a matrix. T indicates compressed data or transformed data, T is used to determine second data, and T may be a vector or a matrix. The at least one first transform base includes a transform base B, or the at least one first transform base includes a transform base $B_1$ and a transform base $B_2$, or the at least one first transform base includes a transform base B().

The transform base may be a vector, a matrix, or a function. Specifically, when the transform base is a vector or a matrix, the transform base may be one vector or matrix, for example, B, or a group of vectors or matrices, for example, $B_1$ and $B_2$. When the transform base is a function B(), a function relationship between the transform base and the first data may be specifically BX or $B_1XB_2$. The function relationship between the transform base and the first data may alternatively be a function of a higher power that is of the first data, or may be transformation of a coordinate system.

In an embodiment, the communication unit is further configured to:

send first indication information to the first device, where the first indication information indicates the at least one first transform base.

In an embodiment, the at least one first transform base includes a second transform base and a third transform base, and the processing unit is specifically configured to:

determine third data based on the second transform base and the first data; and
determine the second data based on the third transform base and the third data.

In an embodiment, the to-be-compressed data further includes fourth data, and the processing unit is specifically configured to:

determine at least one fourth transform base based on a second data type of the fourth data, where the second data type is different from the first data type;
determine fifth data based on the at least one first transform base and the first data, and determine sixth data based on the at least one fourth transform base and the fourth data; and
determine the second data based on the fifth data and the sixth data.

In embodiment, when the communication apparatus 1100 is configured to implement a function of the first device in the foregoing embodiments, the following may be included.

The communication unit is configured to receive second data from the second device.

The processing unit is configured to: determine at least one first transform base based on a first data type of the second data, and restore seventh data from the second data based on the at least one first transform base.

In an embodiment, the processing unit is specifically configured to:
determine, from at least one piece of transform base indication information, first transform base indication information corresponding to the first data type, and use a transform base indicated by the first transform base indication information as the at least one first transform base.

The communication unit is further configured to: send the at least one piece of transform base indication information.

In an embodiment, the at least one piece of transform base indication information is preconfigured.

In an embodiment, the transform base indication information includes at least one of the following:

first information, indicating a data type;
second information, indicating one or more transform bases;
third information, indicating a constraint relationship between data and the one or more transform bases indicated by the second information; and
fourth information, indicating valid time of the one or more transform bases indicated by the second information.

In an embodiment, the communication unit is further configured to:
send configuration information, where the configuration information indicates a transform base set, the transform base set includes Q transform bases, and Q is an integer greater than 0.

In an embodiment, the configuration information further indicates a correspondence between a data type and a transform base set.

In an embodiment, that the second information indicates the transform bases includes:
the second information includes one or more transform bases in the Q transform bases, or the second information includes indexes of the one or more transform bases in the Q transform bases.

In an embodiment, the communication unit is further configured to:
receive first indication information, where the first indication information indicates the at least one first transform base.

It should be noted that, in embodiments of this application, division into units is an example, and is merely a logical function division. During actual implementation, there may be another division manner. Functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in the form of a software product. The computer software product is stored in a storage medium and includes several instructions for instructing a computer device (which may be a personal computer, a server, or a network device) or a processor (processor) to perform all or some of the steps of the methods described in embodiments of this application. The foregoing storage medium includes: any medium that can store program code, for example, a USB flash drive, a removable hard disk, a read-only memory (read-only memory, ROM), a random access memory (random access memory, RAM), a magnetic disk, or an optical disc.

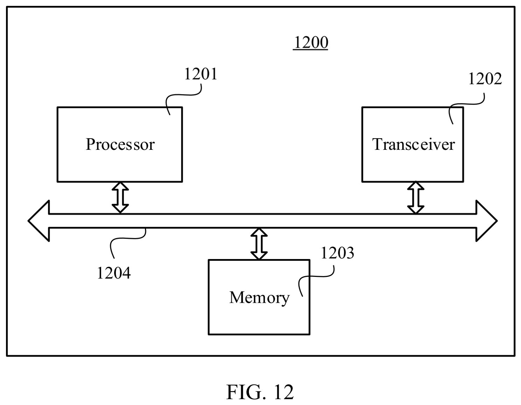

Based on the foregoing embodiments, an embodiment of this application further provides a communication apparatus. Refer to FIG. 12. A communication apparatus 1200 may include a transceiver 1202 and a processor 1201. Optionally, the communication apparatus 1200 may further include a memory 1203. The memory 1203 may be disposed inside the communication apparatus 1200, or may be disposed outside the communication apparatus 1200. The processor 1201 may control the transceiver 1202 to receive and send a message, or the like.

Specifically, the processor 1201 may be a central processing unit (central processing unit, CPU), a network processor (network processor, NP), or a combination of the CPU and the NP. The processor 1201 may further include a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field-programmable gate array (field-programmable gate array, FPGA), a generic array logic (generic array logic, GAL), or any combination thereof.

The transceiver 1202, the processor 1201, and the memory 1203 are connected to each other. Optionally, the transceiver 1202, the processor 1201, and the memory 1203 are connected to each other through a bus 1204. The bus 1204 may be a peripheral component interconnect (Peripheral Component Interconnect, PCI) bus, an extended industry standard architecture (Extended Industry Standard Architecture, EISA) bus, or the like. The bus may be classified into an address bus, a data bus, a control bus, and the like. For ease of representation, only one bold line indicates the bus in FIG. 12, but this does not mean that there is only one bus or only one type of bus.

In an optional implementation, the memory 1203 is configured to store a program and the like. Specifically, the program may include program code, and the program code includes computer operation instructions. The memory 1203 may include a RAM, and may further include a non-volatile memory (non-volatile memory), for example, one or more disk memories. The processor 1201 executes the application program stored in the memory 1203, to implement the foregoing function, thereby implementing a function of the communication apparatus 1200.

For example, the communication apparatus 1200 may be the second device in the foregoing embodiments, or may be the first device in the foregoing embodiments.

In an embodiment, when the communication apparatus 1200 implements a function of the second device in the foregoing method embodiments, the transceiver 1202 may implement receiving and sending operations performed by the second device in the foregoing method embodiments; and the processor 1201 may implement an operation other than the receiving and sending operations performed by the second device in the foregoing method embodiments. Specifically, for related specific descriptions, refer to related descriptions in the foregoing embodiments. Details are not described herein again.

In another embodiment, when the communication apparatus 1200 implements a function of the first device in the foregoing method embodiments, the transceiver 1202 may implement receiving and sending operations performed by the first device in the foregoing method embodiments; and the processor 1201 may implement an operation other than the receiving and sending operations performed by the first device in the foregoing method embodiments. Specifically, for related specific descriptions, refer to related descriptions in the foregoing embodiments. Details are not described herein again.

Based on the foregoing embodiments, an embodiment of this application provides a communication system. The communication system may include the second device, the first device, and the like in the foregoing embodiments.

An embodiment of this application further provides a computer-readable storage medium. The computer-readable storage medium is configured to store a computer program. When the computer program is executed by a computer, the computer may implement the communication method provided in the foregoing method embodiments.

An embodiment of this application further provides a computer program product. The computer program product is configured to store a computer program. When the computer program is executed by a computer, the computer may implement the communication method provided in the foregoing method embodiments.

An embodiment of this application further provides a chip, including a processor. The processor is coupled to a memory, and is configured to invoke a program in the memory, so that the chip implements the communication method provided in the foregoing method embodiments.

An embodiment of this application further provides a chip. The chip is coupled to a memory, and the chip is configured to implement the communication method provided in the foregoing method embodiments.

A person skilled in the art should understand that embodiments of this application may be provided as a method, a system, or a computer program product. Therefore, this application may use a form of hardware only embodiments, software only embodiments, or embodiments with a combination of software and hardware. Moreover, this application may use a form of a computer program product that is implemented on one or more computer-usable storage media (including but not limited to a disk memory, an optical memory, and the like) that include computer-usable program code.

This application is described with reference to the flowcharts and/or block diagrams of the method, the device (system), and the computer program product according to this application. It should be understood that computer program instructions may be used to implement each procedure and/or each block in the flowcharts and/or the block diagrams and a combination of a procedure and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more procedures in the flowcharts and/or in one or more blocks in the block diagrams.

These computer program instructions may be stored in a computer-readable memory that can indicate the computer or any other programmable data processing device to work in a specific manner, so that the instructions stored in the computer-readable memory generate an artifact that includes an instruction apparatus. The instruction apparatus implements a specific function in one or more procedures in the flowcharts and/or in one or more blocks in the block diagrams.

**Claims**

1. A communication method, comprising:

   obtaining to-be-compressed data, wherein the to-be-compressed data comprises first data;
   determining at least one first transform base based on a first data type of the first data;
   determining second data based on the at least one first transform base and the first data; and
   sending the second data to a first device.

2. The method according to claim 1, wherein determining the at least one first transform base based on the first data type of the first data comprises:
   determining, from at least one piece of transform base indication information, first transform base indication information corresponding to the first data type, and using a transform base indicated by the first transform base indication information as the at least one first transform base.

3. The method according to claim 2, wherein the method further comprises:

   receiving the at least one piece of transform base indication information; or
   the at least one piece of transform base indication information is preconfigured; or
   the at least one piece of transform base indication information is generated in real time.

4. The method according to claim 2 or 3, wherein the transform base indication information comprises at least one of the following:

   first information, indicating a data type;
   second information, indicating one or more transform bases;
   third information, indicating a constraint relationship between data and the one or more transform bases indicated by the second information; and
   fourth information, indicating valid time of the one or more transform bases indicated by the second information.

5. The method according to claim 4, wherein the method further comprises:
   receiving configuration information, wherein the configuration information indicates a transform base set, the transform base set comprises Q transform bases, and Q is an integer greater than 0.

6. The method according to claim 5, wherein the configuration information further indicates a correspondence between a data type and a transform base set.

7. The method according to claim 5 or 6, wherein that the second information indicates the transform bases comprises:
   the second information comprises one or more transform bases in the Q transform bases, or the second information comprises indexes of the one or more transform bases in the Q transform bases.

8. The method according to any one of claims 1 to 7, wherein the at least one first transform base and the first data satisfy any one of the following constraint relationships:

   $$X=BT;\ X\approx BT;\ T=BX;\ T=XB;\ X=B_1TB_2;\ X\approx B_1TB_2;\ \text{and}\ T=B(X),$$

   wherein
   X indicates the first data, T is used to determine the second data, and the at least one first transform base comprises a transform base B or B(), or the at least one first transform base comprises a transform base $B_1$ and a transform base $B_2$.

9. The method according to any one of claims 1 to 8, wherein the method further comprises:
   sending first indication information to the first device, wherein the first indication information indicates the at least one first transform base.

10. The method according to any one of claims 1 to 9, wherein the at least one first transform base comprises a second transform base and a third transform base, and determining the second data based on the at least one first transform base and the first data comprises:

> determining third data based on the second transform base and the first data; and
> determining the second data based on the third transform base and the third data.

11. The method according to any one of claims 1 to 9, wherein the to-be-compressed data further comprises fourth data, and the method further comprises:

> determining at least one fourth transform base based on a second data type of the fourth data, wherein the second data type is different from the first data type; and
> determining the second data based on the at least one first transform base and the first data comprises:
>
>> determining fifth data based on the at least one first transform base and the first data, and determining sixth data based on the at least one fourth transform base and the fourth data; and
>> determining the second data based on the fifth data and the sixth data.

12. A communication method, comprising:

> receiving second data from a second device;
> determining at least one first transform base based on a first data type of the second data; and
> restoring seventh data from the second data based on the at least one first transform base.

13. The method according to claim 12, wherein determining the at least one first transform base based on the first data type of the second data comprises:
determining, from at least one piece of transform base indication information, first transform base indication information corresponding to the first data type, and using a transform base indicated by the first transform base indication information as the at least one first transform base.

14. The method according to claim 13, wherein the method further comprises:

> sending the at least one piece of transform base indication information; or
> the at least one piece of transform base indication information is preconfigured.

15. The method according to claim 13 or 14, wherein the transform base indication information comprises at least one of the following:

> first information, indicating a data type;
> second information, indicating one or more transform bases;
> third information, indicating a constraint relationship between data and the one or more transform bases indicated by the second information; and
> fourth information, indicating valid time of the one or more transform bases indicated by the second information.

16. The method according to claim 15, wherein the method further comprises:
sending configuration information, wherein the configuration information indicates a transform base set, the transform base set comprises Q transform bases, and Q is an integer greater than 0.

17. The method according to claim 16, wherein the configuration information further indicates a correspondence between a data type and a transform base set.

18. The method according to claim 16 or 17, wherein that the second information indicates the transform bases comprises:
the second information comprises one or more transform bases in the Q transform bases, or the second information comprises indexes of the one or more transform bases in the Q transform bases.

19. The method according to any one of claims 12 to 18, wherein the method further comprises:
receiving first indication information, wherein the first indication information indicates the at least one first transform base.

20. A communication apparatus, comprising:

    a communication unit, configured to obtain to-be-compressed data, wherein the to-be-compressed data comprises first data; and
    a processing unit, configured to: determine at least one first transform base based on a first data type of the first data, and determine second data based on the at least one first transform base and the first data, wherein the communication unit is configured to send the second data to a first device.

21. The apparatus according to claim 20, wherein the processing unit is specifically configured to:
    determine, from at least one piece of transform base indication information, first transform base indication information corresponding to the first data type, and use a transform base indicated by the first transform base indication information as the at least one first transform base.

22. The apparatus according to claim 21, wherein the communication unit is further configured to:

    receive the at least one piece of transform base indication information; or
    the at least one piece of transform base indication information is preconfigured; or
    the at least one piece of transform base indication information is generated in real time.

23. The apparatus according to claim 21 or 22, wherein the transform base indication information comprises at least one of the following:

    first information, indicating a data type;
    second information, indicating one or more transform bases;
    third information, indicating a constraint relationship between data and the one or more transform bases indicated by the second information; and
    fourth information, indicating valid time of the one or more transform bases indicated by the second information.

24. The apparatus according to claim 23, wherein the communication unit is further configured to:
    receive configuration information, wherein the configuration information indicates a transform base set, the transform base set comprises Q transform bases, and Q is an integer greater than 0.

25. The apparatus according to claim 24, wherein the configuration information further indicates a correspondence between a data type and a transform base set.

26. The apparatus according to claim 24 or 25, wherein that the second information indicates the transform bases comprises:
    the second information comprises one or more transform bases in the Q transform bases, or the second information comprises indexes of the one or more transform bases in the Q transform bases.

27. The apparatus according to any one of claims 20 to 26, wherein the at least one first transform base and the first data satisfy any one of the following constraint relationships:

    $X=BT$; $X \approx BT$; $T=BX$; $T=XB$; $X=B_1TB_2$; $X \approx B_1TB_2$; and $T=B(X)$, wherein
    X indicates the first data, T is used to determine the second data, and the at least one first transform base comprises a transform base B or B(), or the at least one first transform base comprises a transform base $B_1$ and a transform base $B_2$.

28. The apparatus according to any one of claims 20 to 27, wherein the communication unit is further configured to:
    send first indication information to the first device, wherein the first indication information indicates the at least one first transform base.

29. The apparatus according to any one of claims 20 to 28, wherein the at least one first transform base comprises a second transform base and a third transform base, and the processing unit is specifically configured to:

    determine third data based on the second transform base and the first data; and
    determine the second data based on the third transform base and the third data.

30. The apparatus according to any one of claims 20 to 28, wherein the to-be-compressed data further comprises fourth data, and the processing unit is specifically configured to:

determine at least one fourth transform base based on a second data type of the fourth data, wherein the second data type is different from the first data type;
determine fifth data based on the at least one first transform base and the first data, and determine sixth data based on the at least one fourth transform base and the fourth data; and
determine the second data based on the fifth data and the sixth data.

31. A communication apparatus, comprising:

a communication unit, configured to receive second data from a second device; and
a processing unit, configured to: determine at least one first transform base based on a first data type of the second data, and restore seventh data from the second data based on the at least one first transform base.

32. The apparatus according to claim 31, wherein the processing unit is specifically configured to:
determine, from at least one piece of transform base indication information, first transform base indication information corresponding to the first data type, and use a transform base indicated by the first transform base indication information as the at least one first transform base.

33. The apparatus according to claim 32, wherein the communication unit is further configured to:

send the at least one piece of transform base indication information; or
the at least one piece of transform base indication information is preconfigured.

34. The apparatus according to claim 32 or 33, wherein the transform base indication information comprises at least one of the following:

first information, indicating a data type;
second information, indicating one or more transform bases;
third information, indicating a constraint relationship between data and the one or more transform bases indicated by the second information; and
fourth information, indicating valid time of the one or more transform bases indicated by the second information.

35. The apparatus according to claim 34, wherein the communication unit is further configured to:
send configuration information, wherein the configuration information indicates a transform base set, the transform base set comprises Q transform bases, and Q is an integer greater than 0.

36. The apparatus according to claim 35, wherein the configuration information further indicates a correspondence between a data type and a transform base set.

37. The apparatus according to claim 35 or 36, wherein that the second information indicates the transform bases comprises:
the second information comprises one or more transform bases in the Q transform bases, or the second information comprises indexes of the one or more transform bases in the Q transform bases.

38. The apparatus according to any one of claims 31 to 37, wherein the communication unit is further configured to:
receive first indication information, wherein the first indication information indicates the at least one first transform base.

39. A communication apparatus, comprising a processor and a transceiver, wherein

the transceiver is configured to: receive and/or send a signal; and
the processor is coupled to a memory, and is configured to invoke computer instructions in the memory, to cause the method according to any one of claims 1 to 11 to be performed, or to cause the method according to any one of claims 12 to 19 to be performed.

40. A computer-readable storage medium, wherein the computer-readable storage medium stores computer-executable instructions, and when the computer-executable instructions are invoked by the computer, the method according to any one of claims 1 to 11 or the method according to any one of claims 12 to 19 is performed.

41. A computer program product, comprising instructions, wherein when the instructions are run on a computer, the method according to any one of claims 1 to 11 or the method according to any one of claims 12 to 19 is performed.

42. A chip, wherein the chip is coupled to a memory, and is configured to read and execute program instructions stored in the memory, to cause the method according to any one of claims 1 to 11 or the method according to any one of claims 12 to 19 to be performed.

43. A communication system, comprising a first device and a second device, wherein the second device is configured to perform the method according to any one of claims 1 to 11, and the first device is configured to perform the method according to any one of claims 12 to 19.

FIG. 1

Data X → Compression → Data Y → Channel encoding → Modulation → Resource mapping → Antenna mapping → Air interface transmission

FIG. 2

```
┌─────────────────┐                              ┌─────────────────┐
│  Second device  │                              │   First device  │
└────────┬────────┘                              └────────┬────────┘
         │                                                │
┌────────┴────────────────┐                               │
│ Step 301: The second    │                               │
│ device obtains          │                               │
│ to-be-compressed data   │                               │
└────────┬────────────────┘                               │
         │                                                │
┌────────┴────────────────┐                               │
│ Step 302: The second    │                               │
│ device determines at    │                               │
│ least one first         │                               │
│ transform base based on │                               │
│ a first data type of    │                               │
│ first data              │                               │
└────────┬────────────────┘                               │
         │                                                │
┌────────┴────────────────┐                               │
│ Step 303: The second    │                               │
│ device determines       │                               │
│ second data based on    │                               │
│ the at least one first  │                               │
│ transform base and the  │                               │
│ first data              │                               │
└────────┬────────────────┘                               │
         │                                                │
┌────────┴────────────────┐                               │
│ Step 304: The second    │                               │
│ device sends the second │                               │
│ data to the first device│                               │
└────────┬────────────────┘                               │
         │              Second data                       │
         │───────────────────────────────────────────────▶
         │                                                │
         │                               ┌────────────────┴─────────┐
         │                               │ Step 305: The first      │
         │                               │ device restores seventh  │
         │                               │ data from the second     │
         │                               │ data based on the at     │
         │                               │ least one first          │
         │                               │ transform base           │
         │                               └────────────────┬─────────┘
         │                                                │
```

FIG. 3

```
┌──────────┐  ┌──────────────┐    ┌──────────┐  ┌──────────────┐              ┌──────────┐  ┌──────────────┐
│   X₁     │  │  Transform   │    │   X₂     │  │  Transform   │              │   X_K    │  │  Transform   │
│          │  │  base B₁     │    │          │  │  base B₂     │              │          │  │  base B_K    │
└────┬─────┘  └──────┬───────┘    └────┬─────┘  └──────┬───────┘              └────┬─────┘  └──────┬───────┘
     │               │                 │               │                          │               │
     ▼               ▼                 ▼               ▼                          ▼               ▼
┌──────────────────────────┐    ┌──────────────────────────┐              ┌──────────────────────────┐
│  Compress X₁ based on the│    │  Compress X₂ based on the│     ...      │  Compress X_K based on the│
│  transform base B₁       │    │  transform base B₂       │              │  transform base B_K       │
└────────────┬─────────────┘    └────────────┬─────────────┘              └────────────┬─────────────┘
```

Compress $X_1$ based on the transform base $B_1$

Compress $X_2$ based on the transform base $B_2$

Compress $X_K$ based on the transform base $B_K$

| $T_1$ | $T_2$ | ... | $T_K$ |

Quantization and element selection

| Y |

FIG. 4

FIG. 5

EP 4 716 290 A1

Eighth data

FIG. 6

$$T=BX$$

T

X

FIG. 7

$X_1 \approx B^1 T^1$

$X_2 \approx B^2 T^2$

$X_3 \approx B^3 T^3$

$$X = \begin{bmatrix} T^1 \\ T^2 \\ T^3 \end{bmatrix}$$

$$X = B_1 T B_2$$

FIG. 8

35

$T = B_1 X B_2$

T

FIG. 9

$X = B_1 \quad T \quad B_2$

$X_1$

$X_1 \approx B_5 T_1$

$X_2$

$X_2 \approx B_6 T_2$

FIG. 10

1100

Communication unit ⟩ 1101

Processing unit ⟩ 1102

FIG. 11

FIG. 12

## INTERNATIONAL SEARCH REPORT

| International application No. |
| --- |
| **PCT/CN2023/100144** |

| A. | CLASSIFICATION OF SUBJECT MATTER |
| --- | --- |

H04W 28/06(2009.01)i

According to International Patent Classification (IPC) or to both national classification and IPC

| B. | FIELDS SEARCHED |
| --- | --- |

Minimum documentation searched (classification system followed by classification symbols)

IPC:H04W

Documentation searched other than minimum documentation to the extent that such documents are included in the fields searched

Electronic data base consulted during the international search (name of data base and, where practicable, search terms used)

3GPP, CJFD, CNTXT, ENTXTC, VEN: 数据压缩, 变换函数, 变换基, 变换矩阵, 变换向量, 不同类型, 感知, 类型, 数据类型, 压缩, 压缩基, CSI, data compression, transform function, transform basis, transform matrix, transform vector, different types, percept, type, data type, compression, compression basis

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 102314697 A (ZHANG XINGQING) 11 January 2012 (2012-01-11) description, paragraphs [0006]-[0054] | 1-43 |
| A | CN 111064705 A (ECONOMIC TECH RESEARCH INSTITUTE STATE GRID HEBEI ELECTRIC POWER COMPANY et al.) 24 April 2020 (2020-04-24) entire document | 1-43 |
| A | US 2021273649 A1 (BTS SOFTWARE SOLUTIONS, LLC.) 02 September 2021 (2021-09-02) entire document | 1-43 |
| A | WO 2022265401 A1 (LG ELECTRONICS INC.) 22 December 2022 (2022-12-22) entire document | 1-43 |
| A | CN 103096053 A (HUAWEI TECHNOLOGIES CO., LTD.) 08 May 2013 (2013-05-08) entire document | 1-43 |

☐ Further documents are listed in the continuation of Box C. ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **09 October 2023** | **23 October 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

### INTERNATIONAL SEARCH REPORT
Information on patent family members

| | International application No. |
|---|---|
| | **PCT/CN2023/100144** |

| Patent document cited in search report | | | Publication date (day/month/year) | Patent family member(s) | | | Publication date (day/month/year) |
|---|---|---|---|---|---|---|---|
| CN | 102314697 | A | 11 January 2012 | None | | | |
| CN | 111064705 | A | 24 April 2020 | None | | | |
| US | 2021273649 | A1 | 02 September 2021 | None | | | |
| WO | 2022265401 | A1 | 22 December 2022 | None | | | |
| CN | 103096053 | A | 08 May 2013 | WO | 2013064120 | A1 | 10 May 2013 |
| | | | | US | 2014233643 | A1 | 21 August 2014 |
| | | | | EP | 2768220 | A1 | 20 August 2014 |

Form PCT/ISA/210 (patent family annex) (July 2022)